(19) Europäisches Patentamt
European Patent Office
Office européen des brevets

(11) **EP 4 287 653 A1**

(12) **EUROPEAN PATENT APPLICATION**
published in accordance with Art. 153(4) EPC

(43) Date of publication:
**06.12.2023 Bulletin 2023/49**

(51) International Patent Classification (IPC):
***H04R 17/10*** (2006.01)

(21) Application number: **22879565.4**

(86) International application number:
**PCT/CN2022/085557**

(22) Date of filing: **07.04.2022**

(87) International publication number:
**WO 2023/193186 (12.10.2023 Gazette 2023/41)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: Shenzhen Shokz Co., Ltd.
**Shenzhen, Guangdong 518000 (CN)**

(72) Inventors:
• **ZHU, Guangyuan**
**Shenzhen, Guangdong 518000 (CN)**
• **ZHANG, Lei**
**Shenzhen, Guangdong 518000 (CN)**
• **Qi, Xin**
**Shenzhen, Guangdong 518000 (CN)**

(74) Representative: **Wang, Bo**
**Panovision IP**
**Ebersberger Straße 3**
**85570 Markt Schwaben (DE)**

(54) **VIBRATION APPARATUS**

(57) One or more embodiments of the present disclosure relate to a vibration device. The vibration device may include a mass component; one or more piezoelectric components configured to produce a vibration based on an electrical signal; one or more elastic components, wherein at least one elastic component of the one or more elastic components are connected to the mass component and the one or more piezoelectric components; wherein the one or more piezoelectric components include a ring structure, and the one or more piezoelectric components are configured to be parallel to an axial direction of the ring structure based on a vibration direction of the electrical signal.

<u>**100**</u>

FIG. 1

## Description

## TECHNOLOGY FIELD

The present disclosure relates to the technical field of acoustics, and in particular to vibration devices.

## BACKGROUND

A piezoelectric loudspeaker usually uses an inverse piezoelectric effect of piezoelectric ceramic material to produce vibrations to radiate a sound wave outwardly. Compared to a traditional electromagnetic loudspeaker, the piezoelectric loudspeaker may have a high electromechanical transduction efficiency, a low energy consumption, a small size, a high integration, etc. In a current trend of miniaturization and integration of devices, the piezoelectric loudspeaker has an extremely broad prospect and future. However, compared to the traditional electromagnetic loudspeaker, for the piezoelectric loudspeaker, due to a poor low-frequency response of a piezoelectric acoustic device, low-frequency sound quality of the piezoelectric loudspeaker is poor. At the same time, there are a lot of vibration modes in an audible domain (for example, 20 Hz - 20 kHz) of the piezoelectric loudspeaker. Thus, the piezoelectric loudspeaker may not form a relatively straight frequency response curve.

Therefore, it is necessary to provide vibration devices to reduce the vibration modes in the audible domain and also to improve the low-frequency response of the vibration devices.

## SUMMARY

According to embodiments of the present disclosure, a vibration device is provided. The vibration device includes: a mass component; one or more piezoelectric components configured to produce a vibration based on an electrical signal; and one or more elastic components, wherein at least one elastic component of the one or more elastic components are connected to the mass component and the one or more piezoelectric components The one or more piezoelectric components include a ring structure, and the one or more piezoelectric components are configured to be parallel to an axial direction of the ring structure based on a vibration direction of the electrical signal.

In some embodiments, the one or more piezoelectric components include a first piezoelectric component fixed at one end along an axial direction, and another end along the axial direction is connected to the mass component through the at least one elastic component of the one or more elastic components.

In some embodiments, a projection of the mass component along the axial direction of the first piezoelectric component is located within the projection of the first piezoelectric component along the axial direction.

In some embodiments, a shape of the mass component is the ring and the projection of the mass component along the axial direction of the first piezoelectric component is located outside the projection of the first piezoelectric component along the axial direction.

In some embodiments, one side of the mass component is provided with a cover plate along the axial direction of the first piezoelectric component, and the side of the mass component is away from the first piezoelectric component.

In some embodiments, the one or more elastic components connected between the mass component and the first piezoelectric component includes a plurality of elastic components, and the plurality of elastic components are distributed along a circumference of the ring structure.

In some embodiments, the plurality of elastic components is located in a same plane perpendicular to the axial direction of the first piezoelectric component.

In some embodiments, a projection of the plurality of elastic components along the axial direction of the first piezoelectric component includes at least two axes of symmetry perpendicular to each other.

In some embodiments, the shape of the one or more elastic components includes at least one of a folded shape, an S-shape, a sample curve shape, an arc shape, or a straight shape.

In some embodiments, each elastic component of the one or more elastic components has a plurality of bending sections, and the bending directions of the plurality of bending sections are opposite.

In some embodiments, the one or more elastic components include a first spiral structure and a second spiral structure being connected to the mass component and the one or more piezoelectric components, respectively; and an axis of the first spiral structure is the same with an axis of the second spiral structure, and a spiral direction of the first spiral structure is opposite to a spiral direction of the second spiral structure.

In some embodiments, the one or more piezoelectric components include a first piezoelectric component and a second piezoelectric component, wherein the first piezoelectric component includes a first ring structure and the second piezoelectric component include a second ring structure; and the second piezoelectric component is provided on an inner side of the first ring structure.

In some embodiments, the first piezoelectric component is fixed at one end along the axial direction, and another end of the axial direction is fixed to the second piezoelectric component through the at least one elastic component of the one or more piezoelectric components; the projection of the mass component along the axial direction is located within a projection of the second piezoelectric component along the axial direction, and the mass component is connected to the second piezoelectric component through at least another elastic component of the one or more elastic components.

In some embodiments, the second piezoelectric component is fixed at one end along the axial direction, and another end of the axial direction is fixed to the second piezoelectric component through the at least one elastic component of the one or more piezoelectric components; the shape of the mass component is the ring, the projection of the mass component along the axial direction is located outside the projection of the first piezoelectric component along the axial direction, and the mass component is connected to the first piezoelectric component through the at least another elastic component of the one or more elastic components.

In some embodiments, the shape of the mass component is the ring, wherein a projection of the mass component along the axial direction is located between a projection of the first piezoelectric component and a projection of the second piezoelectric component along the axial direction; wherein the mass component is connected to the first piezoelectric component through at least one elastic component of the one or more elastic components, and the mass component is connected to the second piezoelectric component through the at least another elastic component of the one or more elastic components.

In some embodiments, the first piezoelectric component or the second piezoelectric component has a fixed end along the axial direction.

In some embodiments, the one or more elastic components include one or more inner ring elastic components and one or more outer ring elastic components, and bending directions of the one or more inner ring elastic components and the one or more outer ring elastic components are opposite.

In some embodiments, the electrical signal received by the first piezoelectric component and the second piezoelectric component includes a phase difference.

In some embodiments, a phase difference is within a range of 45°-180°.

In some embodiments, the one or more piezoelectric components include at least two first piezoelectric components being connected to each other along the axial direction.

In some embodiments, the mass component is connected to the at least two first piezoelectric components through the one or more elastic components, respectively.

In some embodiments, a count of the at least two first piezoelectric components are two, and displacement changes of the two first piezoelectric components are opposite.

In some embodiments, polarities of connecting surfaces of the two first piezoelectric components are the same and potentials of the connecting surfaces are opposite.

In some embodiments, the polarities of the connecting surfaces of the two first piezoelectric components are opposite and the potentials of the connecting surfaces are the same.

In some embodiments, the one or more piezoelectric components include at least two second piezoelectric components, axes of the at least two second piezoelectric components coincide with axes of the at least two first piezoelectric components, a projection of the at least two second piezoelectric components along the axial direction is located inside a projection of the at least two first ring structures along the axial direction; and the at least two second piezoelectric components are interconnected along the axial direction.

In some embodiments, the at least two second piezoelectric components are connected to the at least two first piezoelectric components through the at least one elastic component of the one or more elastic components.

In some embodiments, the mass component is connected to the at least two first piezoelectric components through the at least one elastic component of the one or more elastic components, respectively, or the mass component is connected to the at least two second piezoelectric components through the at least one elastic component of the one or more elastic components, respectively.

In some embodiments, the mass component is connected to the at least two first piezoelectric components and the at least two second piezoelectric components through the one or more elastic components, respectively.

In some embodiments, the vibration device further includes a piezoelectric beam configured to produce the vibration along the axial direction of the ring structure based on the electrical signal; and the piezoelectric beam is connected to the mass component.

In some embodiments, the piezoelectric beam includes at least one first piezoelectric sheet and at least one second piezoelectric sheet being provided on each side of the piezoelectric beam along the axial direction of the ring structure, respectively, and a polarization direction of the at least one first piezoelectric sheet and a polarization direction of the at least one second piezoelectric sheet are arranged along an opposite direction along the axial direction of the ring structure.

In some embodiments, the mass component includes a first mass component and a second mass component, wherein the first mass component is connected to middle of the piezoelectric beam through the at least one elastic component of the one or more elastic components; and each end of the piezoelectric beam is connected to the piezoelectric beam, respectively.

In some embodiments, the at least one elastic component of the one or more elastic components resonates with the mass component to produce a first resonant peak; and the one or more piezoelectric components resonate to produce a second resonant peak.

In some embodiments, a frequency range of the first resonant peak is within a range of 50 Hz - 2000 Hz.

In some embodiments, a frequency range of the first resonant peak is within a range of 50 Hz - 1000 Hz.

In some embodiments, a frequency range of the second resonant peak is within a range of 1000 Hz - 50000 Hz.

In some embodiments, a frequency range of the second resonant peak is within a range of 2000 Hz - 10000 Hz.

In some embodiments, the frequency range of the second resonant peak is 2000 Hz - 10000 Hz.

In some embodiments, a frequency ratio range of the second resonant peak to the first resonant peak ranges is within a range of 20 - 200.

In some embodiments, at least two piezoelectric components of the one or more piezoelectric components are interconnected such that the vibration device produces a third resonant peak when vibrating, and a frequency of the third resonant peak is located between the first resonant peak and the second resonant peak.

In some embodiments, the at least two piezoelectric components are connected through the at least one elastic component to form a bi-ring structure, and the bi-ring structure resonates to produce the third resonant peak.

**BRIEF DESCRIPTION OF THE DRAWINGS**

The present disclosure is further illustrated in terms of exemplary embodiments, and these exemplary embodiments are described in detail with reference to the drawings. These embodiments are not limiting. In these embodiments, the same number indicates the same structure, wherein:

FIG. 1 is a schematic diagram illustrating an exemplary vibration device according to some embodiments of the present disclosure;

FIG. 2 is a structure diagram illustrating an exemplary vibration device according to some embodiments of the present disclosure;

FIG. 3 is a schematic diagram illustrating a frequency response curve of a vibration device according to some embodiments of the present disclosure;

FIG. 4A is a structure diagram illustrating an exemplary vibration device according to some embodiments of the present disclosure;

FIG. 4B is a schematic diagram illustrating a frequency response curve of a vibration device according to some embodiments of the present disclosure;

FIG. 5 is a structure diagram illustrating an exemplary vibration device according to some embodiments of the present disclosure;

FIG. 6 is a schematic diagram illustrating a frequency response curve of a vibration device according to some embodiments of the present disclosure;

FIG. 7 is a structure diagram illustrating an exemplary vibration device according to some embodiments of the present disclosure;

FIG. 8 is a schematic diagram illustrating a frequency response curve of a vibration device according to some embodiments of the present disclosure;

FIG. 9 is a structure diagram illustrating an exemplary vibration device according to some embodiments of the present disclosure;

FIG. 10 is a schematic diagram illustrating a frequency response curve of a vibration device according to some embodiments of the present disclosure;

FIG. 11 is a schematic diagram illustrating a frequency response curve of a vibration device according to some embodiments of the present disclosure;

FIG. 12 is a structure diagram illustrating an exemplary elastic component according to some embodiments of the present disclosure;

FIG. 13A is a structure diagram illustrating an exemplary vibration device according to some embodiments of the present disclosure;

FIG. 13B is a structure diagram illustrating an exemplary vibration device according to some embodiments of the present disclosure;

FIG. 14A is a structure diagram illustrating an exemplary vibration device according to some embodiments of the present disclosure;

FIG. 14B is a structure diagram illustrating an exemplary vibration device according to some embodiments of the present disclosure;

FIG. 14C is a structure diagram illustrating an exemplary vibration device according to some embodiments of the present disclosure;

FIG. 14D is a schematic diagram illustrating a frequency response curve of a vibration device according to some embodiments of the present disclosure;

FIG. 15A is a structure diagram illustrating an exemplary vibration device according to some embodiments of the present disclosure;

FIG. 15B is a structure diagram illustrating an exemplary vibration device according to some embodiments of the present disclosure;

FIG. 16 is a schematic diagram illustrating an exemplary frequency response curve of a vibration device according to some embodiments of the present disclosure;

FIG. 17 is a structure diagram illustrating an exemplary vibration device according to some embodiments of the present disclosure

FIG. 18 is a structure diagram illustrating an exemplary vibration device according to some embodiments of the present disclosure

FIG. 19 is a structure diagram illustrating an exemplary vibration device according to some embodiments of the present disclosure

FIG. 20A is an exemplary circuit diagram illustrating a first piezoelectric component according to some embodiments of the present disclosure; and

FIG. 20B is an exemplary circuit diagram of a first piezoelectric component according to some embodiments of the present disclosure;

FIG. 21 is a structure diagram illustrating an exemplary vibration device according to some embodiments of the present disclosure;
FIG. 22 is a schematic diagram illustrating a frequency response curve of a vibration device according to some embodiments of the present disclosure;
FIG. 23 is a structure diagram illustrating an exemplary vibration device according to some embodiments of the present disclosure; and
FIG. 24 is a structure diagram illustrating an exemplary vibration device according to some embodiments of the present disclosure.

## DETAILED DESCRIPTION

To more clearly illustrate the technical solutions of the embodiments of the present disclosure, the accompanying drawings that need to be used in the description of the embodiments would be briefly introduced below. Obviously, the accompanying drawing in the following description is merely some examples or embodiments of the present disclosure, and those skilled in the art can apply the present disclosure to other similar situations according to the drawings without any creative effort. Unless obviously obtained from the context or the context illustrates otherwise, the same numeral in the drawings indicates the same structure or operation

It will be understood that the terms "system," "device," "unit," and/or "module" used herein are used to distinguish different components, elements, parts, sections, or assemblies of different levels. However, the terms may be displaced by other expressions if they may achieve the same purpose.

As used in the present disclosure and the appended claims, the singular forms "a," "an," and "the" are intended to include plural referents, unless the content clearly dictates otherwise. Generally, the terms "comprise" and "include" only imply that the clearly identified steps and elements are included, but these steps and elements may not constitute an exclusive list, and the method or device may further include other steps or elements

The flowcharts used in the present disclosure illustrate operations that systems implement according to some embodiments of the present disclosure. It is to be expressly understood, the operations of the flowcharts may be implemented not in order. Conversely, the operations may be implemented in an inverted order, or simultaneously. Moreover, one or more other operations may be added to the flowcharts. One or more operations may be removed from the flowcharts.

Vibration devices provided in embodiments of the present disclosure may be applied to an acoustic output device. The acoustic output device may include, but is not limited to, a bone-conduction loudspeaker, an air-conduction loudspeaker, a bone-conduction hearing aid, or an air-conduction hearing aid. The vibration devices provided in the embodiments of the present disclosure may include a piezoelectric component. The piezoelectric component may convert an input voltage to a displacement output under an inverse piezoelectric effect, and therefore, a vibration device that outputs a displacement according to a piezoelectric component is also referred to as a piezoelectric vibration device. Operating modes of the piezoelectric component in the piezoelectric vibration device usually adopt a d33 operating mode and a d31 operating mode. In the d33 operating mode, a polarization direction of the piezoelectric component is the same as a direction of the displacement output thereof. In the d31 mode, a polarization direction of the piezoelectric component is perpendicular to a direction of the displacement output thereof. Since the piezoelectric component usually has a high resonant frequency, the piezoelectric vibration device may usually boost a high-frequency output, but a low-frequency response of the piezoelectric component is poor and usually has a lot of vibration modes in an audible domain (e.g. 20Hz - 20KHz). Thus, it is difficult to form a flat frequency response curve, thereby affecting sound quality when the vibration device is applied to the acoustic output device.

To solve the problem of poor low-frequency response and a lot of vibration modes in the audible domain of the piezoelectric vibration device, the vibration device provided in some embodiments of the present disclosure may include a mass component and an elastic component. A combination of the elastic component and the mass component may be configured to construct a first resonant peak in the low-frequency range (e.g., 20 Hz - 2000 Hz), while the piezoelectric component is configured to construct a second resonant peak in the high-frequency range (e.g. 1000 Hz - 20000 Hz) to construct a second resonant peak. Thus, a flat curve between the first resonant peak and the second resonant peak may exist. In some embodiments, the piezoelectric component may adopt the d33 operating mode. The high resonant frequency of the piezoelectric component in the d33 operating may reduce the count of vibration modes of the piezoelectric component in the audible domain, and the piezoelectric component in the d33 operating mode under different boundary conditions (e.g., with or without a fixed connection boundary) may also compensate for a loss of the vibration device in a high frequency.

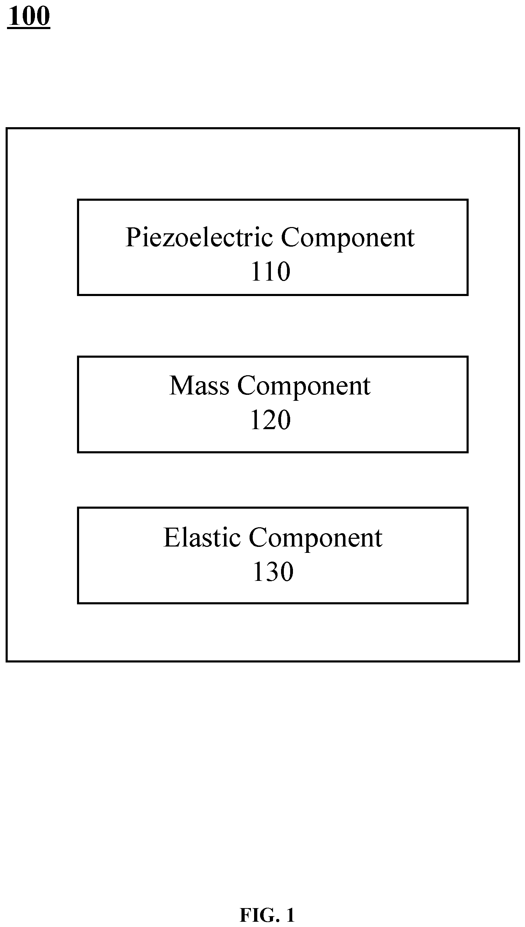

FIG. 1 is a schematic diagram illustrating an exemplary vibration device according to some embodiments of the present disclosure. In some embodiments, the vibration device 100 may include a piezoelectric component 110, a mass component 120, and an elastic component 130. In some embodiments, the mass component 120 may be connected to the piezoelectric component 110 through one or more elastic components. In some embodiments, the elastic component 130 may be one, and the mass component 120 may be connected to the piezoelectric component 120 through one elastic component. In some embodiments, the elastic component 130 may be more than one, and the mass component 120 may be connected to the piezoelectric component 120 through one or more elastic components. In some embodiments, a count of the piezoelectric component 110 may be one or more than one. In some embodiments, the mass component 120 may be connected to one piezoelectric component 110. In some embodiments, the mass component 120 may be connected to a plurality of piezoelectric components 110. In some embodiments, the mass component 120 may also be connected to a plurality of piezoelectric components 110, respectively. In some embodiments, the plurality of piezoelectric components 110 may be interconnected to each other. In some embodiments, the plurality of piezoelectric components 110 may be directly connected to each other. In some embodiments, the plurality of piezoelectric components 110 may also be connected to each other through one or more elastic components 130.

The piezoelectric component 110 may be a component with a piezoelectric effect. In some embodiments, the piezoelectric component 110 may be composed of materials with a piezoelectric effect such as a piezoelectric ceramic, a piezoelectric polymer, etc. In some embodiments, the piezoelectric component 110 may be configured to produce a vibration based on an electrical signal. For example, when an alternating electrical signal is applied to the piezoelectric component 110, the piezoelectric component 110 may deform reciprocally thereby generating the vibration. In some embodiments, a vibration direction of the piezoelectric component 110 may be the same as a polarization direction of the piezoelectric component 110. In some embodiments, the vibration direction of the piezoelectric component 110 and the polarization direction of the piezoelectric component 110 may also be perpendicular to each other.

In some embodiments, a count of piezoelectric components 110 may be one or more. In some embodiments, when a count of piezoelectric components 110 is more than one, the plurality of piezoelectric components 110 may be connected through the one or more elastic components 130. In some embodiments, any one of the one or more piezoelectric components 110 interconnected by the elastic component 130 may be connected again to the mass component 120 through another elastic component 130. In some embodiments, the plurality of piezoelectric components 110 may also be connected in series as a whole along the vibration direction of the plurality of piezoelectric components 110, and the piezoelectric components 110 connected in series may be connected to the mass component 120 through the one or more elastic components 130.

In some embodiments, the piezoelectric component 110 may be a single ring structure. The single ring structure may refer that a projection of the piezoelectric component 110 along an axial direction is a ring shape. For example, when a count of piezoelectric components 110 is one, the piezoelectric component 110 is a single ring structure. In some embodiments, the piezoelectric component 110 may be a multi-ring structure (e.g., a bi-ring structure, a tri-ring structure, etc.). The multi-ring structure may refer that a projection of the piezoelectric component 110 along the axial direction includes a plurality of ring shapes. For example, the count of piezoelectric components 110 is two, the ring structures of two piezoelectric components 110 may have different ring outer diameters, and the two piezoelectric components 110 may be connected to each other through the one or more elastic components 130. At this time, the two piezoelectric components 110 and the one or more elastic components 130 may be connected to the two piezoelectric components 110 to form a bi-ring structure. A piezoelectric component with a ring structure (e.g., a single ring structure or a bi-ring structure) may have a high resonant frequency, thereby reducing a count of vibration modes of the piezoelectric component in the audible domain. After constructing a low-frequency peak through the structural design (e.g., connecting an elastic component and a mass component) according to some embodiments of the present disclosure, a flat curve may be formed between a low-frequency peak and a resonant peak of the piezoelectric component. When the vibration device 100 is applied to an acoustic output device, the sound quality of the sound output by the vibration device 100 or the acoustic output device may be improved.

In some embodiments, the piezoelectric component 110 may be a single-layer ring structure. In some embodiments, the piezoelectric component 110 may also be a double-layer ring structure. For example, the one or more piezoelectric components 110 may include at least two piezoelectric components. The at least two piezoelectric components may be interconnected along the axial direction to form a double-layer ring structure. The mass component 120 may be connected to the at least two piezoelectric components through the one or more elastic components 130, respectively. In some embodiments, the piezoelectric component 110 may also be a multilayer ring structure composed of more piezoelectric components interconnected along the axial direction.

In some embodiments, the polarization direction of the piezoelectric component 110 may be the same as a direction of the displacement output of the piezoelectric component 110. In some embodiments, a displacement output of the piezoelectric component 110 may be configured as a vibration end, such that the polarization direction of the piezoelectric component 110 may be the same as the vibration direction of the piezoelectric component 110. It may be understood that the piezoelectric component 110 may produce vibrations along the polarization direction of the piezoelectric component 110 under an action of the electrical signal. In some embodiments, the one or more piezoelectric components 110 may include a ring structure, and the ring structure may be a ring structure. The ring structure may be a columnar structure with a ring-shaped end surface. In some embodiments, the polarization direction of the piezoelectric component 110 may be parallel to the axial direction of the ring structure, and the piezoelectric component 110 may produce vibrations along the axial direction of the ring structure of the piezoelectric component 110 under the action of the electrical signal. An axis of the ring structure may be a virtual line connecting form centers of two ring end surfaces of the columnar structure and form centers connecting any truncated surfaces parallel to the ring end surfaces. For example, if the ring structure is a circular columnar structure, and the axis may be a straight-line connecting centers of circles of two circular end surfaces. As another example, if the ring structure is a trapezoidal ring column structure, the axis may be a straight-line connecting form centers of two trapezoidal ring end surfaces. In some embodiments, the axial direction of the ring structure is perpendicular to the ring surface of the ring structure. In some embodiments, the shape of the ring end surface of the ring structure may include, but is not limited to, a circular ring, an elliptical ring, a curved ring, or a polygonal ring. In some embodiments, the polarization direction of the piezoelectric component 110 may be parallel to the axial direction of the ring structure, and the piezoelectric component 110 may produce vibrations along the axial direction of the ring structure of the piezoelectric component 110 under the action of an electrical signal.

The mass component 120 may be a component with a certain mass. In some embodiments, the mass component 120 may be configured as a vibrating plate or diaphragm of the vibration device 100 to ensure the vibration device 100 to output vibrations through the mass component 120. In some embodiments, the material of the mass component 120 may be a metallic material or a non-metallic material. The metallic material may include, but are not limited to, steel (e.g., stainless steel, carbon steel, etc.), lightweight alloy (e.g., aluminum alloy, beryllium copper, magnesium alloy, titanium alloy, etc.), or the like, or any combination thereof. The non-metallic material may include, but are not limited to, polymeric material, glass fiber, carbon fiber, graphite fiber, silicon carbide fiber, etc. In some embodiments, a projection of the mass component 120 along the vibration direction of the mass component 120 may be a regular and/or irregular polygon such as a circle, a ring, a rectangle, a pentagon, a hexagon, etc.

In some embodiments, the mass component 120 may be connected to the piezoelectric component 110 through the one or more elastic components 130, and the vibrations output by the piezoelectric component 110 may be transmitted to the mass component 120 through the one or more elastic components 130. In some embodiments, the mass component 120 and the one or more elastic components 130 connected thereto may resonate to cause the vibration device 100 to produce a first resonant peak. A magnitude of a first resonant frequency corresponding to the first resonant peak is influenced by a mass of the mass component 120 and an elasticity coefficient of the elastic component 130. In some embodiments, a frequency of the first resonant peak (also referred to as the first resonant frequency) may be expressed by equation (1):

$$f = \frac{1}{2\pi}\sqrt{\frac{k}{m}}, (1)$$

where $f$ denotes the first resonant frequency, $m$ denotes the mass of the mass component 120, and $k$ denotes the elasticity coefficient of the elastic component 120. According to equation (1), the magnitude of the first resonant frequency corresponding to the first resonant peak may be adjusted by adjusting the mass of the mass component 120 and/or the elasticity coefficient of the elastic component 120, so that the first resonant peak may be located within a desired frequency range.

In some embodiments, the mass component 120 may be connected to an inner side of the piezoelectric component 110 through the one or more elastic components 130. In some embodiments, when the piezoelectric component 110 produces the vibrations based on the electrical signal, the vibrations may be transmitted to the mass component 120 through the one or more elastic components 130, such that the mass component 120 produces vibrations parallel to the vibration direction of the piezoelectric component 110. In some embodiments, the projection of the mass component 120 along the vibration direction of the mass component 120 may be located within the projection of the piezoelectric component 110 along the vibration direction of the piezoelectric component 110. In some embodiments, the mass component 120 may be a solid columnar structure, e.g., a solid cylindrical structure, when the mass component 120 is located inside the piezoelectric component 110. In other embodiments, when the mass component 120 is located inside the piezoelectric component 110, the mass component 120 may also be other shaped structures, for example, a ring structure with an outer diameter smaller than an inner diameter of the piezoelectric component 110.

In some embodiments, the mass component 120 may be located outside the piezoelectric component 110. When the mass component 120 is located outside the piezoelectric component 110, a shape of the mass component 120 may be a ring, and the inner diameter of the ring may be greater than the outer diameter of the ring of the piezoelectric component 110, such that the projection of the mass component 120 along the axial direction of the piezoelectric component 110 may be located outside of the projection of the piezoelectric component 110 along the axial direction of the piezoelectric component 110.

In some embodiments, the mass component 120 may be located between a plurality of piezoelectric components 110. In some embodiments, the piezoelectric components 110 may include a first piezoelectric component and a second piezoelectric component of different diameters. The second piezoelectric component may be arranged on an inner side of the first piezoelectric component, and the mass component 120 may be located between the first piezoelectric component and the second piezoelectric component. In some embodiments, the shape of the mass component 120 may be the ring, and the projection of the mass component 120 along the axial direction of the piezoelectric component 110 may be located between projections of the first piezoelectric component and the second piezoelectric component along the axial direction of the piezoelectric component 110.

In some embodiments, when the shape of the mass component 120 is a ring, one side of the mass component 120 along the axial direction of the piezoelectric component 110 away from the piezoelectric component 110 may be provided with a cover plate. The cover plate may seal the side of the mass component 120 along the axial direction of the piezoelectric component 110 away from the piezoelectric component 110. For example, if the shape of the mass component 120 is a ring, and the cover plate may be a ring structure with a circumferential side of the cover plate being connected to the side of the mass component 120 along the axial direction of the piezoelectric component 110 away from the piezoelectric component 110. The cover plate may be configured as a vibrating plate for transmitting a vibration signal by arranging the cover plate on the side of the mass component 120 along the axial direction of the piezoelectric component 110 away from the piezoelectric component 110. In some embodiments, when the vibration device 100 is applied to the acoustic device, the cover plate may also be configured to connect the mass component 120 to other structures of the acoustic device, for example, a diaphragm, which facilitates the vibration device 100 to drive the diaphragm to vibrate through the mass component 120.

The elastic component 130 may be a component that may deform elastically under an action of an external load. In some embodiments, the elastic component 130 may be a material with a good elasticity (i.e., susceptible to deform elastically), such that the elastic component 130 and the mass component 120 connected thereto has a good vibration responsiveness. In some embodiments, a material of the elastic component 130 may include, but is not limited to, one or more of a metallic material, a polymeric material, a rubber-like material, etc. In some embodiments, a count of the elastic component 130 may be one or more. In some embodiments, the mass component 120 may be connected to the piezoelectric component 110 through one elastic component 130. For example, a shape of the elastic component 130 may be a ring, and the mass component 120 and the piezoelectric component 110 may be connected through one elastic component 130 in a ring shape. In some embodiments, the mass component 120 may be connected to the piezoelectric component 110 through a plurality of elastic components 130. For example, the plurality of elastic components 130 may include a rod structure, and the plurality of elastic components 130 may be distributed along a circumference of the piezoelectric component 110 and may be connected to the mass component 120.

In some embodiments, the elastic component 130 may be a vibration transmitting sheet. When the one or more elastic components 130 is connected to the mass component 120 and the piezoelectric component 110, the one or more elastic components 130 may transmit the vibrations produced by the piezoelectric component 110 to the mass component 120, such that the mass component 120 may produce the vibrations. In some embodiments, the elastic component 130 may also be a connecting rod arranged on the vibration transmitting sheet, thereby a manufacturing process of the vibration device 100 easy and fast.

In some embodiments, the elastic component 130 may be a single-layer structure. The single-layer structure may refer that the one or more elastic components 130 are located in a same plane perpendicular to the axial direction of the piezoelectric component 110. In some embodiments, the elastic component 130 may be a multilayer structure. The multilayer structure may refer that the plurality of elastic components are located within different planes perpendicular to the axial direction of the piezoelectric component 110.

In some embodiments, a shape of the one or more elastic components 130 may include, but is not limited to, at least one of a folded shape, an S-shape, a spline curve shape, an arc shape, and a straight-line shape. The shape of the one or more elastic components 130 may be arranged according to the needs of the vibration device 100 (e.g., the first resonant peak, a simple manufacturing process of the vibration device 100, etc.).

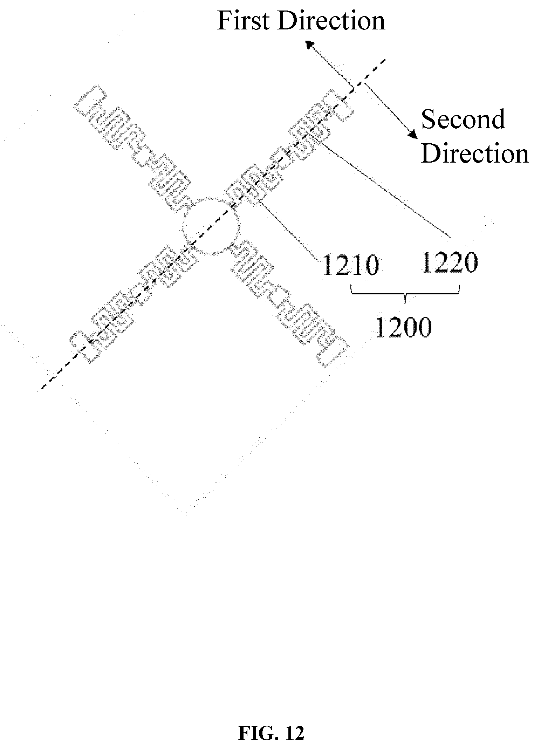

In some embodiments, the elastic component 130 may have a plurality of bending segments. In some embodiments, bending directions of the plurality of bending segments may be the same. In some embodiments, the bending directions of the plurality of bending segments may also be different. In some embodiments, the bending directions of the plurality of bending segments may also be opposite. For example, when a shape of the elastic component 130 is a bending line, the bending line may include a first bending segment and a second bending segment. A bending direction of the first bending segment may be a first direction first. A bending direction of the second bending segment may be a second direction first, and the second direction may be arranged in an opposite direction from the first direction. More descriptions regarding the bending direction of the elastic component and the arrangement thereof may be found in FIG. 12 and the relative descriptions thereof in the present disclosure.

In some embodiments, during a vibration process of the vibration device 100, the one or more elastic components 130 may provide a tangential stress to the mass component 120 because the elastic component 130 has a curved shape, and when the plurality of elastic components 130 provide the tangential stress to the mass component 120 in a same direction, the mass component 120 may have a tendency to rotate around its central axis. The tangential stress may be a stress provided by the elastic component 130 to the mass component 120 (and/or the piezoelectric component 110), the stress may be tangential to an arbitrary cross section on the mass component 120 perpendicular to the vibration direction of the mass component 120, and the tangential stress may cause the mass component 120 to tend to rotate about a central axis thereof. In some embodiments, the bending segments on the elastic component 130 with different bending directions may provide tangential stresses with different curls to the mass component 120 connected to the elastic component 130. A curl may be a vector operator for measuring a rotational nature of a vector field of the tangential stress, a magnitude of the vector operator may measure the curl of the vector field of the tangential stress, and a direction of the vector operator may measure a rotation direction of the vector field of the tangential stress. A direction of the curl may be determined using a right hand rule according to the rotation direction. For example, when the mass component 120 is rotated (or tends to rotate) under an action of the tangential stress provided by the elastic component 130, according to the right hand rule, a bending direction of four fingers may be the same as a rotation (or tendency to rotate) direction of the ring structure, at this time a pointing direction of the thumb may be the direction of the curl. In some embodiments, bending segments on the one or more elastic components 130 with opposite directions may provide a tangential stress of an opposite curl to the mass component 120 connected to the one or more elastic components 130. The tangential stresses provided to the mass component 120 by different portions of the elastic component 130 may be configured to cancel out each other by providing the bending segments with the tangential stress of an opposite rotation. Thus, the elastic component 130 overall does not provide the tangential stress to the mass component 120, thereby avoiding a rotation tendency occurring to the mass component 120.

In some embodiments, when a count of elastic components 130 is more than one, bending directions of adjacent elastic components 130 may be different. In some embodiments, when the count of elastic components 130 is more than one, the bending directions of the adjacent elastic components 130 may be opposite. In some embodiments, when the plurality of elastic components 130 have a single-layer structure, projections of the plurality of elastic components 130 along the axial direction of the piezoelectric component 110 may have two axes of symmetry perpendicular to each other, such that the bending directions of the adjacent elastic components 130 are opposite. For example, the one or more elastic components 130 may be X-shaped, and a plurality of X-shaped elastic components have two axes of symmetry perpendicular to each other. The curl directions of the tangential stresses of the mass component 120 provided by the plurality of elastic components 130 with opposite bending directions may be opposite, so that the tangential stresses provided by the plurality of elastic components 130 with opposite bending directions to the mass component 120 may cancel out each other, thereby avoiding the rotation tendency occurring to the mass component 120.

In some embodiments, when the plurality of elastic components 130 have a multilayer structure, adjacent layers of the plurality of components 130 may have different bending directions. In some embodiments, the elastic component 130 may be a double-layer structure, and the elastic component 130 may include a first spiral structure and a second spiral structure. The first spiral structure and the second spiral structure may be connected to the mass component 120 and the one or more piezoelectric components 110 within different planes perpendicular to the axial direction of the piezoelectric component 110, respectively. In some embodiments, axes of the first spiral structure and the second spiral structure may be the same, and spiral directions may be opposite. The rotational direction of the tangential stresses provided by different layers of the elastic component 130 to the mass component 120 may be opposite by providing the first spiral structure and the second spiral structure with opposite spiral directions, so that the tangential stresses provided by the plurality of elastic components 130 with different layers to the mass component 120 may cancel out each other, thereby avoiding the rotation tendency occurring to the mass component 120.

In some embodiments, the vibration device 100 may form at least two resonant peaks in the audible frequency domain. In some embodiments, at least one elastic component 130 of the one or more elastic components 130 may resonate with the mass component 120 to produce a first resonant peak. The one or more piezoelectric components 110 may resonate to produce a second resonant peak. In some embodiments, a frequency corresponding to the first resonant peak (which may also be referred to as a first resonant frequency) may be within the low-frequency range (e.g., less than 2000 Hz), and a frequency corresponding to the second resonant peak (which may also be referred to as a second resonant frequency) may be within the mid to high frequency (e.g., greater than 1000 Hz) range. In some embodiments, the second resonant frequency corresponding to the second resonant peak may be higher than the first resonant frequency corresponding to the first resonant peak. In some embodiments, a resonant valley does not exist between the second resonant peak and the first resonant peak, and a flat curve may be formed between the first resonant peak and the second resonant peak, thereby improving the sound quality of an output sound of the vibration device 100.

In some embodiments, it is known according to equation (1) that a frequency range of the first resonant frequency corresponding to the first resonant peak may be adjusted by adjusting the mass of the mass component 120 and/or the elasticity coefficient of the one or more elastic components 130. In some embodiments, the first resonant frequency corresponding to the first resonant peak may be within a range of 50 Hz - 2000 Hz. In some embodiments, the first resonant frequency corresponding to the first resonant peak may be within a range of 50 Hz - 1500 Hz. In some embodiments, the first resonant frequency corresponding to the first resonant peak may be within a range of 50 Hz - 1000 Hz. In some embodiments, the first resonant frequency corresponding to the first resonant peak may be within a range of 50 Hz - 500 Hz. In some embodiments, the first resonant frequency corresponding to the first resonant peak may be within a range of 50 Hz - 200 Hz.

In some embodiments, the second resonant frequency corresponding to the second resonant peak may be adjusted by adjusting structural parameters (e.g., size, shape, mass, material, etc.) of the piezoelectric component 110. In some embodiments, the second resonant frequency may be an intrinsic frequency of the piezoelectric component 110. In some embodiments, the second resonant frequency corresponding to the second resonant peak may be within a range of 1000 Hz - 50000 Hz. In some embodiments, the second resonant frequency corresponding to the second resonant peak may be within a range of 1000 Hz - 40000 Hz. In some embodiments, the second resonant frequency corresponding to the second resonant peak may be within a range of 1000 Hz - 30000 Hz. In some embodiments, the second resonant frequency corresponding to the second resonant peak may be within a range of 1000 Hz - 20000 Hz. In some embodiments, the second resonant frequency corresponding to the second resonant peak may be within a range of 1000 Hz - 10000 Hz. In some embodiments, the second resonant frequency corresponding to the second resonant peak may be within a range of 2000 Hz - 10000 Hz. In some embodiments, the second resonant frequency corresponding to the second resonant peak may be within a range of 3000 Hz - 10000 Hz.

In some embodiments, to ensure that the frequency response curve of the vibration device 100 has a large range of flat areas between the first resonant peak and the second resonant peak, thereby ensuring a low-frequency response of the vibration device 100 and the sound quality of the output sound, a frequency ratio of the second resonant frequency corresponding to the second resonant peak to the first resonant frequency corresponding to the first resonant peak may be within a range of 20 - 200. In some embodiments, a frequency ratio of the second resonant frequency corresponding to the second resonant peak to the first resonant frequency corresponding to the first resonant peak may be within a range of 30 - 180. In some embodiments, a frequency ratio of the second resonant frequency corresponding to the second resonant peak to the first resonant frequency corresponding to the first resonant peak may be within a range of 40 - 160. In some embodiments, a frequency ratio of the second resonant frequency corresponding to the second resonant peak to the first resonant frequency corresponding to the first resonant peak may be within a range of 50 - 150.

In some embodiments, the vibration device 100 may also have a third resonant peak when vibrating, and a frequency corresponding to the third resonant peak (which may also be referred to as a third resonant frequency) may be between the first resonant frequency corresponding to the first resonant peak and the second resonant frequency corresponding to the second resonant peak. In some embodiments, the vibration device 100 may have a bi-ring structure, and a third resonant peak may be produced by resonating through the bi-ring structure. In some embodiments, where the piezoelectric component 110 is a bi-ring structure and the mass component 120 is located at the innermost side, an inner piezoelectric component (e.g., the second piezoelectric component) and the mass component 120 (and the one or more elastic components 130 connecting the inner piezoelectric component to the mass component 120) may constitute an overall mass. Since the overall mass is greater than the mass of the mass component 120 (e.g., the vibrational mass increases), a resonant frequency of a low-frequency peak of the vibration device 100 decreases, which is shown by a movement of the first resonant peak in the frequency response curve of the vibration device 100 toward a lower frequency, and the vibration device 100 with a bi-ring structure may also produce the third resonant peak located between the first resonant peak and the second resonant peak when vibrating. In some embodiments, the third resonant peak may not affect a location of a high frequency resonant peak (e.g., the second resonant peak). The third resonant peak may raise a high-frequency resonant valley, thereby improving a high-frequency response of the vibration device 100.

In some embodiments, a maximum dimension of the projection of the vibration device 100 along the vibration direction may be not greater than 60 mm to meet a miniaturization needs of the vibration device 100. The maximum dimension of the projection of the vibration device 100 along the vibration direction is a maximum value of a distance between any two points on an outer contour of the projection. For example, if a maximum contour of the projection of the vibration device 100 along the vibration direction is a circle, a maximum dimension of the projection of the vibration device 100 along the vibration direction is a diameter of the circle. As another example, if a maximum contour of the projection of the vibration device 100 along the vibration direction is an ellipse, a maximum dimension of the projection of the vibration device 100 along the vibration direction is a long axis of the ellipse. As another example, if a maximum contour of the projection of the vibration device 100 along the vibration direction is a square, a maximum dimension of the projection of the vibration device 100 along the vibration direction is a diagonal of the square. In some embodiments, when the mass component 120 is arranged at an outermost side of the vibration device 100, a maximum dimension of the projection of the vibration device 100 along the vibration direction may be a maximum dimension of the projection of the mass component 120 along the vibration direction. In some embodiments, when the piezoelectric component 110 is arranged at the outermost side of the vibration device 100, a maximum dimension of the projection of the vibration device 100 along the vibration direction may be a maximum dimension of the projection of the piezoelectric component 110 along the vibration direction.

In some embodiments, the vibration device 100 may also include a piezoelectric beam. The piezoelectric beam may be directly connected or indirectly connected to the mass component 120. For example, the piezoelectric beam may be located on one side of the mass component 120 away from the piezoelectric component 110 and directly connected to the mass component 120. As another example, the piezoelectric beam may be indirectly connected to the mass component 120 through the one or more elastic components 130. In some embodiments, the piezoelectric beam may be configured to produce vibrations along the axial direction of the ring structure of the piezoelectric component 110 based on the electrical signal. In some embodiments, the piezoelectric beam may include at least one first piezoelectric sheet and at least one second piezoelectric sheet. The at least one first piezoelectric sheet and the at least one second piezoelectric sheet may be provided on two sides of the piezoelectric beam along the axial direction of the ring structure of the piezoelectric component 110, respectively. In some embodiments, polarization directions of the at least one first piezoelectric sheet and the at least one second piezoelectric sheet may be arranged opposite along the axial direction of the ring structure. That is, the polarization direction of the first piezoelectric sheet is opposite to the polarization direction of the second piezoelectric sheet along the axial direction of the ring structure of the piezoelectric component 110. In some embodiments, displacement output directions of the first piezoelectric sheet and the second piezoelectric sheet may be perpendicular to the polarization direction. In some embodiments, since the polarization direction of the first piezoelectric sheet is opposite to the polarization direction of the second piezoelectric sheet, when the first piezoelectric sheet and the second piezoelectric sheet are simultaneously connected to a voltage signal in the same direction, the first piezoelectric sheet and the second piezoelectric sheet may produce a displacement in opposite directions, thereby causing the piezoelectric beam to vibrate. For example, the first piezoelectric sheet may contract along the direction perpendicular to the axial direction of the ring structure, and the second piezoelectric sheet may elongate along the direction perpendicular to the axial direction of the ring structure, thereby causing the piezoelectric beam to produce the vibration along the axial direction of the ring structure.

In some embodiments, the mass component 120 may include a first mass component and a second mass component, and the first mass component may be connected to a central portion of the piezoelectric beam through at least one elastic component of the one or more elastic components 130. In some embodiments, the first mass component may also be connected to the one or more piezoelectric components 110 through the one or more elastic components 130. In some embodiments, two sides of the piezoelectric beam may be connected the piezoelectric beam, respectively. In some embodiments, the first mass component may also be connected to other locations of the piezoelectric beam (e.g., close to end locations of the piezoelectric beam) through the at least one elastic component 130 of the one or more elastic components 130. In some embodiments, the vibration of the vibration device 100 may be output through the second mass component at ends of the piezoelectric beam. In some embodiments, the vibrations of the vibration device 100 may also be output through the first mass component.

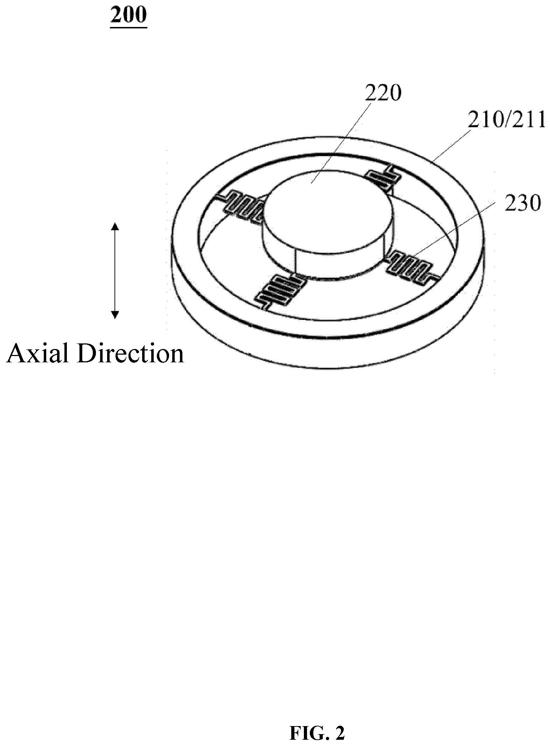

FIG. 2 is a structure diagram illustrating an exemplary vibration device according to some embodiments of the present disclosure. As shown in FIG. 2, a vibration device 200 may include one or more piezoelectric components 210, a mass component 220, and one or more elastic components 230. At least one elastic component 230 of the one or more elastic components 230 may connect the mass component 220 and the piezoelectric component 210.

In some embodiments, the one or more piezoelectric components 210 may include a first piezoelectric component 211. The first piezoelectric component 211 may be a ring structure. One end of the first piezoelectric component 211 may be fixed along the axial direction (also referred to as a fixed end), and the mass component 220 may be connected to a location other than the one end on the first piezoelectric component 211 through the one or more elastic components 230. In some embodiments, the one end of the piezoelectric component (e.g., the first piezoelectric component, the second piezoelectric component, etc.) is an entire area with a certain thickness (e.g., 0.1%, 5%, or any thickness in a range of 0.1% to 30% of a total thickness of the ring structure) along the axial direction of the ring structure from one ring end surface of the ring structure of the piezoelectric component. For example, "the one end of the one or more first piezoelectric component 211 along the axial direction is fixed" may refer that the one ring end surface of the one or more first piezoelectric component 211 is fixed. As another example, "the one end of the one or more first piezoelectric component 211 along the axial direction is fixed" may refer that inner and/or outer sides of the ring structure with a certain thickness area close to the one ring end surface of the one or more first piezoelectric component 211 is fixed. In some embodiments, the elastic component 230 may be connected to another ring end surface opposite the fixed end. In some embodiments, the elastic component 230 may also be connected to the inner side of the ring structure and a connection location of the inner side is not included on the fixed end.

In some embodiments, the mass component 220 may be located inside the first piezoelectric component 211. The projection of the mass component 220 along the axial direction of the first piezoelectric component 211 may be located within the projection of the first piezoelectric component 211 along the axial direction. The piezoelectric component 210, the elastic component 230, and the mass component 220 may be sequentially arranged from outside to inside within the projection along the axial direction of the piezoelectric component 210. In some embodiments, when the mass component 220 is located inside the first piezoelectric component 211, a shape of the mass component 220 may be columnar (as shown in FIG. 2), ring-shaped, etc.

In some embodiments, the plurality of elastic component 230 connecting the mass component 220 to the first piezoelectric component 211 may be distributed along a circumference of the ring. In some embodiments, the one end of the one or more elastic components 230 may be connected to any surface of the mass component 220 along the axial direction (e.g., close to a surface of the piezoelectric component 210). In other embodiments, the one end of the one or more elastic components 230 may also be connected to a circumferential surface of the mass component 220. In some embodiments, another end of the one or more elastic components 230 may be connected to any surface on the non-fixed end of the piezoelectric component 210. For example, in some embodiments, another end of the one or more elastic components 230 may be connected to a ring end surface on the piezoelectric component 210 close to the mass component 220. As another example, in some embodiments, another end of the elastic component 230 may also be connected to a circumferential inner surface of the piezoelectric component 210. The connection location between the one or more elastic components 230 and the mass component 220 and/or the piezoelectric component 210 may be arranged according to the structural feasibility of the vibration device 200.

In some embodiments, the mass component 220 and the elastic component 230 may resonate to produce a first resonant peak, and the resonant of the first piezoelectric component 211 may produce a second resonant peak. A location of the first resonant peak (i.e., a magnitude of the first resonant frequency corresponding to the first resonant peak) may be determined by a mass of the mass component 220 and an elasticity coefficient of the one or more elastic components 230. A location of the second resonant peak (i.e., a magnitude of the second resonant frequency corresponding to the second resonant peak) may be determined by structural parameters (e.g., dimensions) of the piezoelectric component 210.

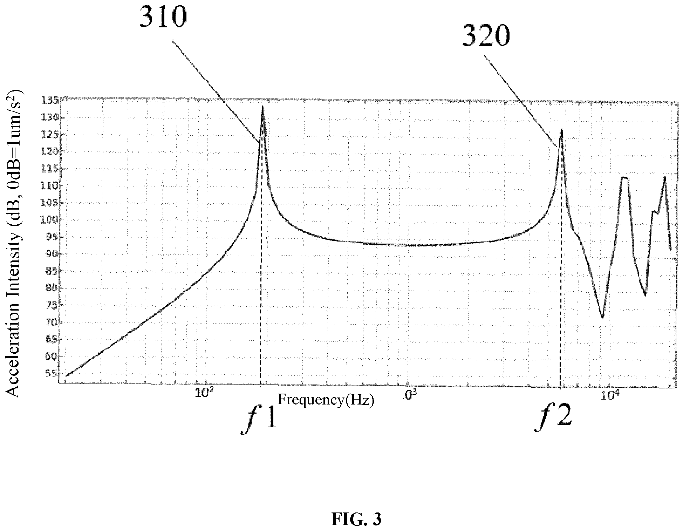

FIG. 3 is a schematic diagram illustrating a frequency response curve of a vibration device 200 according to some embodiments of the present disclosure. As shown in FIG. 3, a horizontal coordinate denotes a resonant frequency of the vibration device 200 in Hz, and a vertical coordinate denotes an acceleration output intensity of the vibration device 200 in dB. In some embodiments, as shown in FIG. 3, the vibration device 200 may form at least two resonant peaks in an audible domain (e.g., 20 Hz - 20 KHz). A first resonant peak 310 may be produced by resonating through the mass component 220 and the one or more elastic components 230, and a second resonant peak 320 may be produced by resonating through the piezoelectric component 210. In some embodiments, a frequency $f1$ of the first resonant peak 310 of the vibration device 200 may be within a range of 50Hz - 2000Hz. In some embodiments, a frequency $f1$ of the first resonant peak 310 of the vibration device 200 may be within a range of 50Hz - 500Hz. In some embodiments, a frequency $f1$ of the first resonant peak 310 of the vibration device 200 may be within a range of 50Hz - 300Hz. In some embodiments, a frequency $f1$ of the first resonant peak 310 of the vibration device 200 may be within a range of 50Hz - 300Hz. In some embodiments, a frequency $f1$ of the first resonant peak 310 of the vibration device 200 may be within a range of 50 Hz - 200 Hz. In some embodiments, a frequency $f1$ of the first resonant peak 310 of the vibration device 200 may be within a range of 100 Hz - 200 Hz. In some embodiments, a frequency $f2$ of the second resonant peak 320 of the vibration device 200 may be within a range of 100 Hz - 200 Hz. In some embodiments, a frequency f2 of the second resonant peak 320 of the vibration device 200 may be within a range of 1000 Hz - 20000 Hz. In some embodiments, a frequency $f2$ of the second resonant peak 320 of the vibration device 200 may be within a range of 2000 Hz - 10000 Hz. In some embodiments, a frequency $f2$ of the second resonant peak 320 of the vibration device 200 may be within a range of 2000Hz - 7000Hz. In some embodiments, a frequency $f2$ of the second resonant peak 320 of the vibration device 200 may be within a range of 3000Hz - 7000Hz. In some embodiments, a frequency $f2$ of the second resonant peak 320 of the vibration device 200 may be within a range of 4000Hz - 7000Hz. In some embodiments, a frequency $f2$ of the second resonant peak 320 of the vibration device 200 may be within a range of 5000Hz - 7000Hz. In some embodiments, a frequency response curve between the first resonant peak 310 and the second resonant peak 320 may be relatively straight, the vibration device 200 has a high output response capability within a frequency range between the first resonant frequency $f1$ and the second resonant frequency $f2$. Thus, when the vibration device 200 is applied to an acoustic output device, a sound with high sound quality may be output.

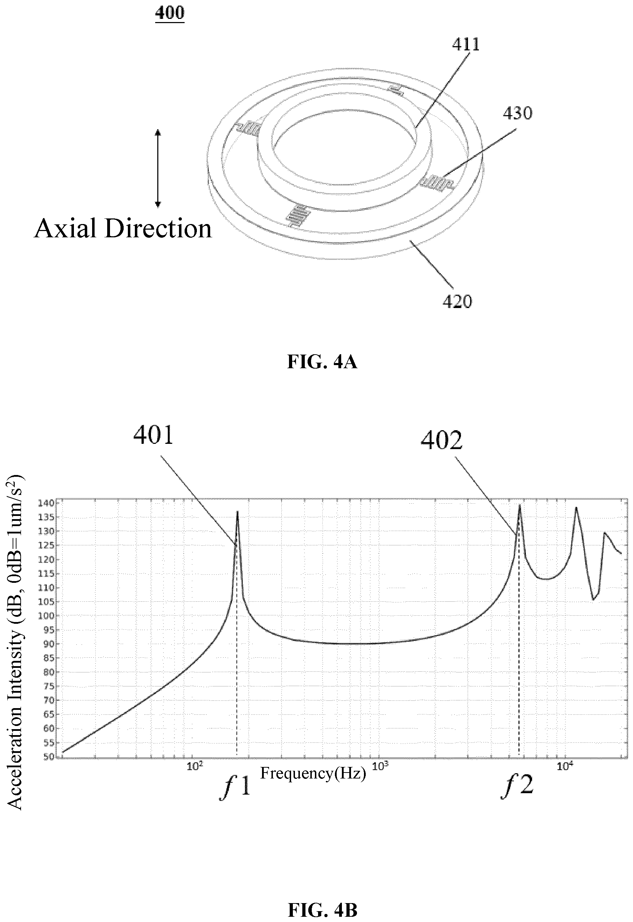

FIG. 4A is a structure diagram illustrating an exemplary vibration device according to some embodiments of the present disclosure. In some embodiments, as shown in FIG. 4A, a mass component 420 may also be located outside a first piezoelectric component 411. A projection of the mass component 420 along an axial direction of the first piezoelectric component 411 may be located outside a projection of the first piezoelectric component 411 along the axial direction. The mass component 420 and the first piezoelectric component 411 may be connected to each other by an elastic component 430. The first piezoelectric component 411, the elastic component 430, and the mass component 420 may be arranged sequentially from inside to outside along the projection of the axial direction of the first piezoelectric component 411. In some embodiments, a shape of the mass component 420 may be a ring when the mass component 420 is located outside the first piezoelectric component 411.

In some embodiments, when the mass component 420 is located outside the first piezoelectric component 411, one side of the mass component 420 along the axial direction of the first piezoelectric component 411 away from the first piezoelectric component 411 may be provided with a cover plate. The cover plate may seal the one side of the mass component 420 along the axial direction of the first piezoelectric component 411 away from the first piezoelectric component 411. For example, the cover plate may be a ring structure, a circumferential side of the cover plate is aligned with and tightly connected to the one side of the mass component 420 along the axial direction of the first piezoelectric component 411 away from the first piezoelectric component 411. The cover plate may be configured as a vibration plate for transmitting vibration signals by providing the cover plate on the side of the mass component 420 along the axial direction of the first piezoelectric component 411 away from the first piezoelectric component 411. The cover plate may also be configured to connect the mass component 420 to other structures (e.g., a diaphragm) of the vibration device 400.

FIG. 4B is a frequency response diagram illustrating a vibration device according to some embodiments of the present disclosure. When the mass component 420 is located outside the first piezoelectric component 411, the frequency response diagram of the vibration device 400 may be as shown in FIG. 4B. In some embodiments, a frequency $f1$ (also referred to as the first resonant frequency) of a first resonant peak 401 of the vibration device 400 may be within a range of 50Hz - 4000Hz. In some embodiments, a frequency $f1$ of the first resonant peak 401 of the vibration device 400 may be within a range of 50Hz - 500Hz. In some embodiments, a frequency $f1$ of the first resonant peak 401 of the vibration device 400 may be within a range of 50Hz - 500Hz. in some embodiments, a frequency $f1$ of the first resonant peak 401 of the vibration device 400 may be within a range of 50 Hz - 300 Hz. In some embodiments, a frequency $f1$ of the first resonant peak 401 of the vibration device 400 may be within a range of 50 Hz - 200 Hz. In some embodiments, a frequency $f1$ of the first resonant peak 401 of the vibration device 400 may be within a range of 100 Hz - 200 Hz. In some embodiments, a frequency $f1$ of the first resonant peak 401 of the vibration device 400 may be within a range of 50 Hz - 500 Hz. In some embodiments, a frequency $f2$ of a second

resonant peak 402 of the vibration device 400 (also referred to as the second resonant frequency) may be within a range of 1000Hz - 40000Hz. In some embodiments, a frequency $f2$ of a second resonant peak 402 of the vibration device 400 may be within a range of 4000Hz - 10000Hz. In some embodiments, a frequency $f2$ of a second resonant peak 402 of the vibration device 400 may be within a range of 4000Hz - 8000Hz. In some embodiments, a frequency $f2$ of a second resonant peak 402 of the vibration device 400 may be within a range of 4000Hz - 7000Hz. In some embodiments, t a frequency $f2$ of a second resonant peak 402 of the vibration device 400 may be within a range of 4000Hz - 6000Hz.

In some embodiments, the one or more piezoelectric components may not only include a first piezoelectric component, but also a second piezoelectric component. The second piezoelectric component may be arranged on the inner side of the first piezoelectric component. In some embodiments, the first piezoelectric component may include a first ring structure and the second piezoelectric component may include a second ring structure. The second piezoelectric component may be arranged on the inner side of the first ring structure.

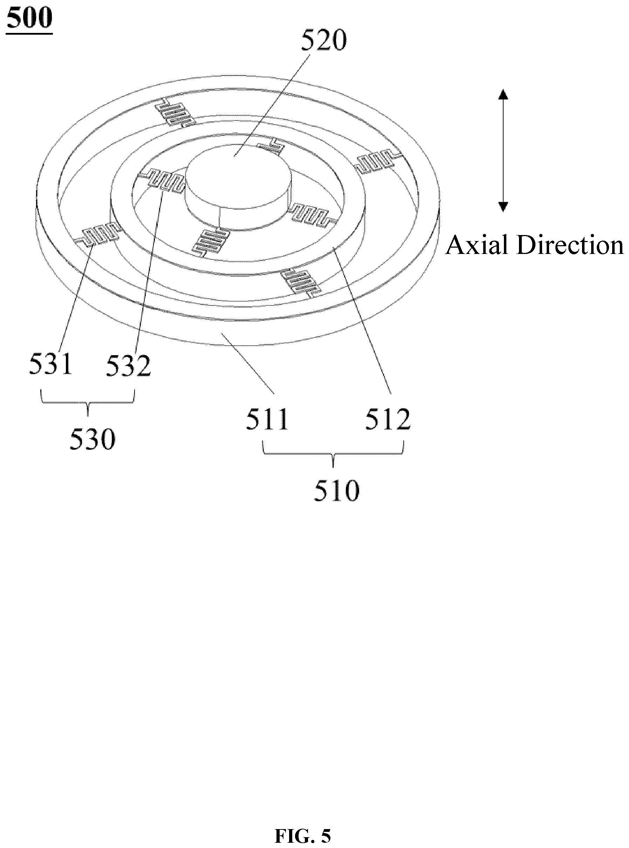

FIG. 5 is a structure diagram illustrating an exemplary vibration device according to some embodiments of the present disclosure. As shown in FIG. 5, a vibration device 500 may include one or more piezoelectric components 510, a mass component 520, and one or more elastic components 530. At least one elastic component 530 of the one or more elastic components 530 may be configured to connect the mass component 520 and the piezoelectric component 510.

In some embodiments, the one or more piezoelectric components 510 may include a first piezoelectric component 511 and a second piezoelectric component 512. The first piezoelectric component 511 may include a first ring structure and the second piezoelectric component 512 may include a second ring structure. The second piezoelectric component 512 may be arranged on the inner side of the first ring structure. In some embodiments, one end of the first piezoelectric component 511 along the axial direction (e.g., one end away from a mass component 520) may be fixed, and the second piezoelectric component 512 may be connected to a location other than a fixed end of the first piezoelectric component 511 through at least one elastic component 530 of the one or more elastic components 530. A projection of the mass component 520 along the axial direction may be located within a projection of the second piezoelectric component 512 along the projection of the mass component 520, and the mass component 520 may be connected to the second piezoelectric component 512 through at least another elastic component 530 of the one or more elastic components 530. In some embodiments, the one or more elastic components 530 may include a first elastic component 531 and a second elastic component 532. The first elastic component 531 may be located between the first piezoelectric component 511 and the second piezoelectric component 512, and the first piezoelectric component 511 and the second piezoelectric component 512 may be connected to each other through the first elastic component 531. The second elastic component 532 may be located between the second piezoelectric component 512 and the mass component 520, and the second piezoelectric component 512 and the mass component 520 may be connected through the second elastic component 532.

In some embodiments, the second piezoelectric component 512 and the mass component 520 (and the elastic component connecting the second piezoelectric component 512 and the mass component 520) may form an overall mass by providing a second piezoelectric component 512 in the vibration device 500. When an overall mass resonates with the one or more elastic components connecting the overall mass and the first piezoelectric component 511, since the overall mass is greater than the mass component, a first resonant peak of the vibration device 500 may move to a lower frequency. When the vibration device 500 vibrates, a bi-ring structure may further resonate to produce a third resonant peak located between the first resonant peak and the second resonant peak, which may be shown in a frequency response curve of the vibration device 500 as a formation of an additional resonant peak (i.e., the third resonant peak) at a location between the first resonant peak and the second resonant peak. In some embodiments, a third resonant frequency corresponding to the third resonant peak may be located between the first resonant frequency corresponding to the first resonant peak and the second resonant frequency corresponding to the second resonant peak.

In some embodiments, a frequency of the first resonant peak of the vibration device 500 with a bi-ring structure may be within a range of 50 Hz - 2000 Hz. In some embodiments, a frequency of the first resonant peak of the vibration device 500 with a bi-ring structure may be within a range of 50 Hz - 1000 Hz. In some embodiments, a frequency of the first resonant peak of the vibration device 500 with a bi-ring structure may be within a range of 50 Hz - 300 Hz. In some embodiments, a frequency of the first resonant peak of the vibration device 500 with a bi-ring structure may be within a range of 50 Hz - 200 Hz. In some embodiments, a frequency of the first resonant peak of the vibration device 500 with a bi-ring structure may be within a range of 50Hz - 100Hz.

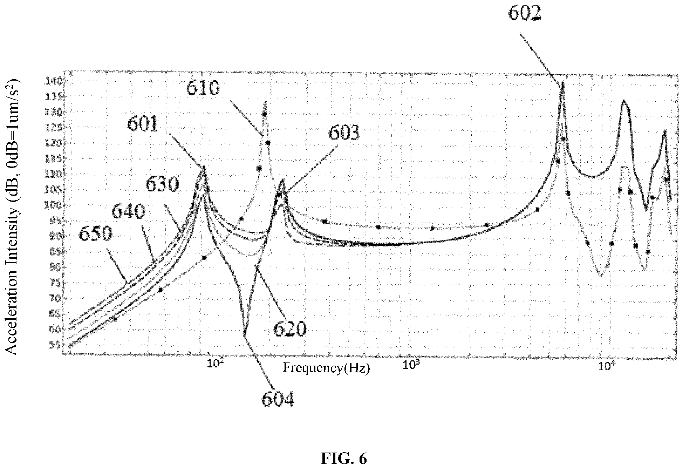

FIG. 6 is a schematic diagram illustrating a frequency response curve of a vibration device 500 according to some embodiments of the present disclosure. A curve 610 may denote a frequency response curve of the vibration device provided with only a first piezoelectric component, and a curve 620 denotes a frequency response curve of the vibration device provided with a first piezoelectric component and a second piezoelectric component. A phase difference between an electrical signal received by the first piezoelectric component and the second piezoelectric component is 0 degree. In some embodiments, when the vibration device is additionally provided with the second piezoelectric component, the frequency response curve 620 of the vibration device may not only form a first resonant peak 601 and a second resonant peak 602, but also an additional resonant peak, i.e., a third resonant peak 603. Since a direction of an output from the first piezoelectric component and a direction of an output from the second piezoelectric component at the resonant valley 604 is opposite, vibration outputs at the resonant valley 604 cancel out each other. In some embodiments, a location of the resonant valley 604 is related to dimensions of the first piezoelectric component and the second piezoelectric component and a shape of the elastic component. In some embodiments, the resonant valley 604 may be filled by modulating a phase of an electrical signal between the first piezoelectric component and the second piezoelectric component. In some embodiments, the low frequency sensitivity of the vibration device may increase with an increase in a phase difference of electrical signals of the first piezoelectric component and the second piezoelectric component. The phase difference of the electrical signal between the first piezoelectric component and the second piezoelectric component does not substantially affect a high frequency feature of the vibration device.

Continuously, as shown in FIG. 6, a curve 630 denotes a frequency response curve of the vibration device when a phase difference between the electrical signals received by the first piezoelectric component and the second piezoelectric component is 45°, a curve 640 denotes a frequency response curve of the vibration device when a phase difference between the electrical signals received by the first piezoelectric component and the second piezoelectric component is 90°, and a curve 650 denotes a frequency response curve of the vibration device when a phase difference between the electrical signals received by the first piezoelectric component and the second piezoelectric component is 135°. Comparing curves 630, 640 and 650, with other parameters being the same, the greater the phase difference between the electrical signals received by the first piezoelectric component and the second piezoelectric component, the shallower the resonant valley formed between the first resonant peak and the third resonant peak, and the better the low-frequency response of the vibration device.

In some embodiments, to ensure a low-frequency response of the vibration device, a phase difference between the electrical signals received by the first piezoelectric component and the second piezoelectric component may be within a range of 45°-180°. In some embodiments, to ensure a low-frequency response of the vibration device, a phase difference of the electrical signal received by the first piezoelectric component and the second piezoelectric component may be within a range of 60°-180°. In some embodiments, to ensure a low-frequency response of the vibration device, a phase difference between the electrical signals received by the first piezoelectric component and the second piezoelectric component may be within a range of 80°-180°. In some embodiments, to ensure a low-frequency response of the vibration device, a phase difference between the electrical signals received by the first piezoelectric component and the second piezoelectric component may be within a range of 100°-180°. In some embodiments, to ensure a low-frequency response of the vibration device, a phase difference between the electrical signals received by the first piezoelectric component and the second piezoelectric component may be within a range of 45°-120°. In some embodiments, to ensure a low-frequency response of the vibration device, a phase difference of the electrical signal received by the first piezoelectric component and the second piezoelectric component may be within a range of 45°-90°.

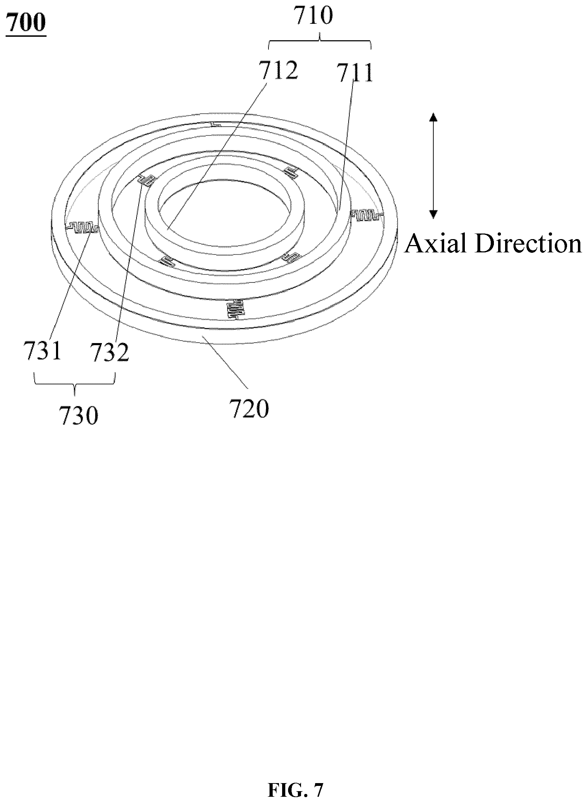

In some embodiments, when the vibration device includes the first piezoelectric component and the second piezoelectric component, the mass component may be located outside the first piezoelectric component. FIG. 7 is a structure diagram illustrating an exemplary vibration device according to some embodiments of the present disclosure. As shown in FIG. 7, one or more piezoelectric components 710 may include a first piezoelectric component 711 and a second piezoelectric component 712. The first piezoelectric component 711 may include a first ring structure and the second piezoelectric component 712 may include a second ring structure. The second piezoelectric component 712 may be arranged in an inner side of the first ring structure. In some embodiments, one end of the second piezoelectric component 712 along the axial direction of the ring structure may be fixed, and the first piezoelectric component 711 may be connected to the second piezoelectric component 712 at a location other than a fixed end of the second piezoelectric component 712 through at least one elastic component 730 of one or more elastic components 730 (e.g., the second elastic component 732). A shape of the mass component 720 may be a ring, and a projection of the mass component 720 along the axial direction may be located outside a projection of the first piezoelectric component 711 along the axial direction. The mass component 720 may be connected to the first piezoelectric component 711 through at least another of the one or more elastic components 730 (e.g., the first elastic component 731).

In some embodiments, the vibration device 700 may include a first piezoelectric component 711 and a second piezoelectric component 712. The mass component 720 may be provided with a cover plate on one side of the mass component 720 along the axial direction of the first piezoelectric component 711 away from the first piezoelectric component 711 when the mass component 720 is located outside the first piezoelectric component 711.

In some embodiments, the first piezoelectric component 711 and the mass component 720 (and the elastic component connecting the first piezoelectric component 711 to the mass component 720) may form an integral mass. When the integral mass resonates with the elastic component connecting the integral mass to the second piezoelectric component 712, the first resonant peak of the vibration device 700 may move to a lower frequency, and a bi-ring structure of the vibration device 700 may resonate to produce a third resonant peak located between the first resonant peak and the second resonant peak. In some embodiments, a frequency range of the first resonant peak of the vibration device 700 with the bi-ring structure may be similar to a frequency range of the first resonant peak of the vibration device 500, which will not be described herein.

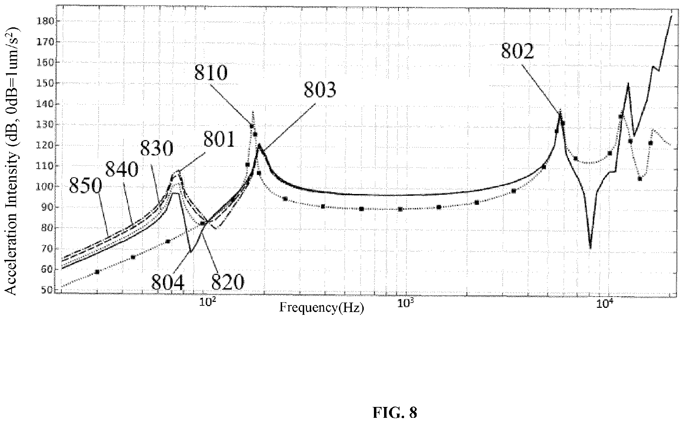

FIG. 8 is a schematic diagram illustrating a frequency response curve of a vibration device 700 according to some embodiments of the present disclosure. A curve 810 may denote a frequency response curve of the vibration device provided with only a first piezoelectric component, and a curve 820 denotes a frequency response curve of a vibration device provided with a first piezoelectric component and a second piezoelectric component. A phase difference between electrical signals received by the first piezoelectric component and the second piezoelectric component is 0 degree. Comparing the curve 810 to the curve 820, when the second piezoelectric component is additionally arranged in the vibration device, the first resonant peak 801 and the second resonant peak 802 are formed in the frequency response curve 820 of the vibration device, and a third resonant peak 803 is formed in the frequency response curve 820 of the vibration device. In some embodiments, while the third resonant peak 803 is formed in the frequency response curve 820 of the vibration device, a resonant valley 804 may be formed between the first resonant peak 801 and the third resonant peak 803. The resonant valley 804 may be formed when the vibration output of the first piezoelectric component and the second piezoelectric component at a frequency location corresponding to the resonant valley 804 are in opposite directions, causing vibration outputs to cancel out each other. In some embodiments, a location of the resonant valley 804 is related to dimensions of the first piezoelectric component and the second piezoelectric component and a shape of the elastic component. In some embodiments, the resonant valley 804 may be filled by modulating a phase of an electrical signal between the first piezoelectric component and the second piezoelectric component. In some embodiments, a low-frequency sensitivity of the vibration device may increase with an increase in a phase difference of the electrical signal of the first piezoelectric component and the second piezoelectric component. The phase difference of the electrical signal between the first piezoelectric component and the second piezoelectric component may not substantially affect a high-frequency feature of the vibration device.

In some embodiments, there may be a phase difference between the electrical signals received by the first piezoelectric component and the second piezoelectric component, and the phase difference may affect an amplitude of the resonant valley 804. Continuously, as shown in FIG. 8, a curve 830 denotes a frequency response curve of the vibration device when a phase difference between the electrical signals received by the first piezoelectric component and the second piezoelectric component is 45°, a curve 840 denotes a frequency response curve of the vibration device when a phase difference between the electrical signals received by the first piezoelectric component and the second piezoelectric component is 90°, and a curve 850 denotes a frequency response curve of the vibration device when a phase difference between the electrical signals received by the first piezoelectric component and the second piezoelectric component is 135°. Comparing curve 830, curve 840 and curve 850, when other parameters are the same, the greater the phase difference between the electrical signals received by the first piezoelectric component and the second piezoelectric component, the shallower the resonant valley formed between the first resonant peak and the third resonant peak, and the better the low-frequency response of the vibration device. In some embodiments, a specific arrangement range of the phase difference between the electrical signals received by the first piezoelectric component and the second piezoelectric component may be found described elsewhere in the present disclosure.

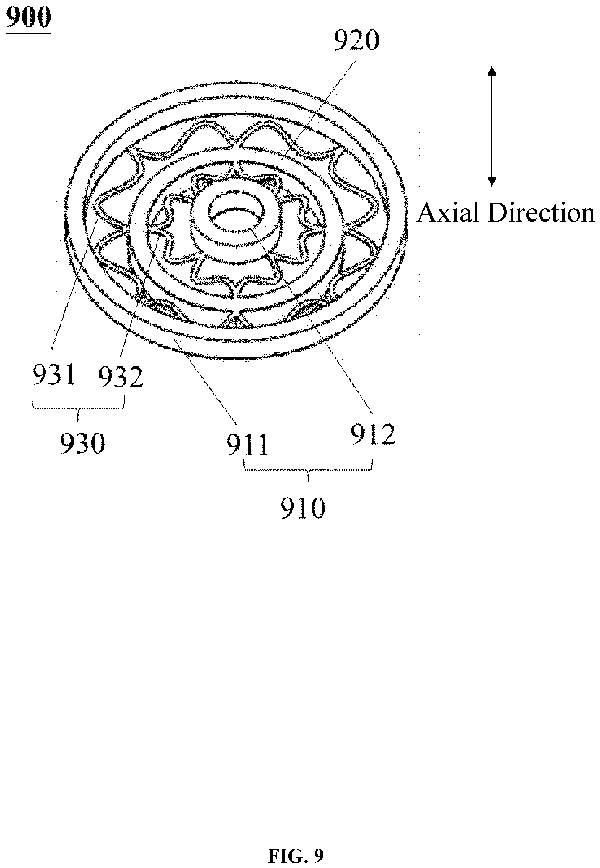

In some embodiments, when the vibration device includes the first piezoelectric component and the second piezoelectric component, the mass component may be located between the first piezoelectric component and the second piezoelectric component. FIG. 9 is a schematic diagram illustrating an exemplary structure of a vibration device according to some embodiments of the present disclosure. As shown in FIG. 9, a shape of the mass component 920 may be a ring and a mass component 920 may be located between a first ring structure of a first piezoelectric component 911 and a second ring structure of a second piezoelectric component 912. A projection of the mass component 920 along the axial direction may be located between a projection of the first piezoelectric component 911 and the second piezoelectric component 912 along the axial direction. The mass component 920 may be connected to the first piezoelectric component 911 through at least one elastic component 930 of one or more elastic components 930 (e.g., a first elastic component 931), and the mass component 920 may be connected to the second piezoelectric component 912 through at least another elastic component 930 of the one or more elastic components (e.g., a second elastic component 932). In some embodiments, a shape of the one or more elastic components 930 (e.g., the first elastic component 931 and/or the second elastic component 932) may be S-shaped, and bending directions of one or more adjacent S-shaped elastic components 930 may be opposite, such that the one or more adjacent S-shaped elastic components 930 may provide tangential stresses of opposite curl to the mass component 920, thereby avoiding a rotation tendency of rotating around the axial direction occurring to the mass component 920, and avoiding a rotational mode occurring to the vibration device 900. In some embodiments, as shown in FIG. 9, a connection location of the one or more adjacent S-shaped elastic components 930 may be the same location on the mass component 920 or the piezoelectric component 910 (e.g., the first piezoelectric component 911 and/or the second piezoelectric component 912). In other embodiments, the connection location of the one or more adjacent S-shaped elastic components 930 on the mass component 920 or the piezoelectric component 910 (e.g., the first piezoelectric component 911 and/or the second piezoelectric component 912) may also be different.

In some embodiments, the first piezoelectric component 911 or the second piezoelectric component 912 may have a fixed end along the axial direction. In some embodiments, when the first piezoelectric component 911 is fixed at one end along the axial direction, the second piezoelectric component 912 may be free arranged at two ends along the axial direction. The second piezoelectric component 912 may be configured as a piezoelectric free ring. The first piezoelectric component 911 may be configured as a piezoelectric fixed ring. Or when the second piezoelectric component 912 is fixed at one end along the axial direction, the first piezoelectric component 911 may be free arranged at both end surfaces of the axial direction. The first piezoelectric component 911 may be configured as a piezoelectric free ring and the second piezoelectric component 912 may be configured as a piezoelectric fixed ring. In some embodiments, the vibration device 900 may have different frequency response curves when different piezoelectric components in the at least one piezoelectric component 910 of the one or more piezoelectric component 910 have the fixed end along the axial direction. An overall mass formed by the piezoelectric free ring and the mass component 920 (and the elastic component connecting the piezoelectric free ring to the mass component 920) may resonate with the elastic component connecting the overall mass and the piezoelectric fixed ring, such that a first resonant peak move to a lower frequency. The piezoelectric free ring and the piezoelectric fixed ring may be indirectly connected (i.e., the mass component 920 and the second elastic component 932 are connected through the first elastic component 931) so that the piezoelectric free ring and the piezoelectric fixed ring resonant may form a third resonant peak in the frequency response curve when the vibration device 900 is vibrating. A third resonant frequency corresponding to the third resonant peak may be located between the first resonant frequency corresponding to the first resonant peak and the second resonant frequency corresponding to the second resonant peak. In some embodiments, a frequency range of the first resonant peak of the vibration device 900 may be similar to a frequency range of the first resonant peak of the vibration device 500, which will not be described herein.

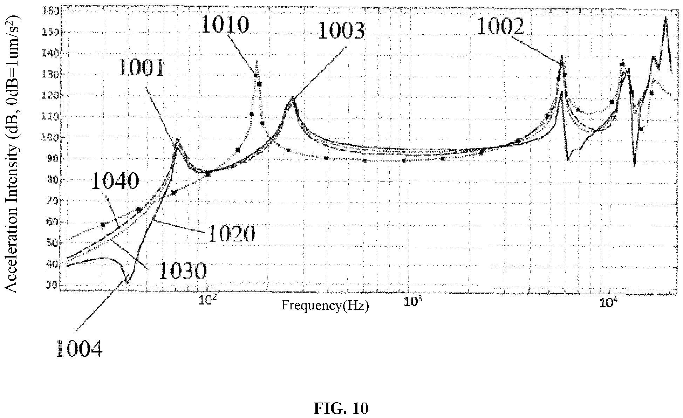

FIG. 10 is a schematic diagram illustrating a frequency response curve of a vibration device according to some embodiments of the present disclosure. In FIG. 10, The frequency response curve other than curve 1010 may be a frequency response curve of the vibration device (e.g., a vibration device 900) where the first piezoelectric component (e.g., a first piezoelectric component 911) has a fixed end along the axial direction. As shown in FIG. 10, a curve 1010 may denote a frequency response curve of the vibration device (e.g., vibration device 200) provided with only a first piezoelectric component, and a curve 1020 denote a frequency response curve of the vibration device provided with the first piezoelectric component and the second piezoelectric component. A phase difference between electrical signals received by the first piezoelectric component and the second piezoelectric component is 0°. Comparing curve 1010 to curve 1020, when the vibration device is provided with the first piezoelectric component and the second piezoelectric component, a third resonant peak 1003 other than the first resonant peak 1001 and the second resonant peak 1002 may also be formed in the frequency response curve 1020 of the vibration device. In some embodiments, the third resonant peak 1003 may be produced by resonating through the first piezoelectric component and the second piezoelectric component. In some embodiments, a resonant valley 1004 formed in the frequency response curve 1020 of the vibration device may be located before the first resonant peak 1001 when the mass component is located between the first piezoelectric component and the second piezoelectric component as compared to when the mass component is located outside the first piezoelectric component (or when the mass component is located inside the second piezoelectric component). In some embodiments, the resonant valley 1004 may also be populated by modulating the phase of the electrical signal between the first piezoelectric component and the second piezoelectric component for the resonant valley 1004.

Referring back to FIG. 10, curves 1030 and 1040 may denote the frequency response curves of the vibration device when the phase difference between the electrical signals received by the first piezoelectric component and the second piezoelectric component are 90° and 180°, respectively. Comparing curves 1030 and 1040, when other parameters are the same, the greater the phase difference between the electrical signals received by the first piezoelectric component and the second piezoelectric component, the shallower the resonant valley formed before the first resonant peak, and the better the low-frequency response of the vibration device. In some embodiments, a specific arrangement range of the phase difference between the electrical signals received by the first piezoelectric component and the second piezoelectric component may be found described elsewhere in the present disclosure.

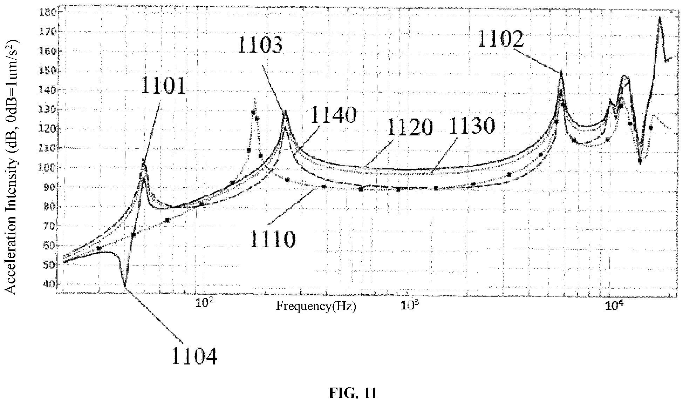

FIG. 11 is a schematic diagram illustrating a frequency response curve of a vibration device according to some embodiments of the present disclosure. In FIG.

11, a frequency response curve other than curve 1110 may be a frequency response curve of the vibration device where a second piezoelectric component (e.g., a second piezoelectric component 912) has a fixed end along the axial direction. A curve 1110 may denote a frequency response curve of the vibration device (e.g., vibration device 200) provided with only a first piezoelectric component, and a curve 1120 denotes a frequency response curve of the vibration device (e.g., a vibration device 900) provided with the first piezoelectric component and the second piezoelectric component. A phase difference between the electrical signals received by the first piezoelectric component and the second piezoelectric component is 0°. Comparing curve 1110 and curve 1120, when the vibration device is provided with the first piezoelectric component and the second piezoelectric component, a third resonant peak 1103 other than a first resonant peak 1101 and a second resonant peak 1102 may also be formed in a frequency response curve 1120 of the vibration device. In some embodiments, the third resonant peak 1103 may be produced by resonating through the first piezoelectric component and the second piezoelectric component. In some embodiments, as compared to when the mass component is located outside the first piezoelectric component (or alternatively, when the mass component is located inside the second piezoelectric component), a resonant valley 1104 formed in the frequency response curve 1120 of the vibration device may be located before the first resonant peak 1101 when the mass component is located between the first piezoelectric component and the second piezoelectric component. The resonant valley 1104 may also be filled by modulating the phase of the electrical signal between the first piezoelectric component and the second piezoelectric component.

Referring back to FIG. 11, curves 1130 and 1140 may denote the frequency response curves of the vibration device when the phase difference between the electrical signals received by the first piezoelectric component and the second piezoelectric component are 90° and 180°, respectively. Comparing curves 1130 and 1140, when the other parameters are the same, the greater the phase difference between the electrical signals received by the first piezoelectric component and the second piezoelectric component, the shallower the resonant valley formed before the first resonant peak, and the better the low-frequency response of the vibration device. In some embodiments, a specific arrangement range of the phase difference between the electrical signals received by the first piezoelectric component and the second piezoelectric component may be found described elsewhere in the present disclosure.

In some embodiments, in a piezoelectric vibration device (e.g., the vibration device 200, the vibration device 400, the vibration device 500, the vibration device 700, and the vibration device 900), an elastic component may be configured to provide elasticity to ensure the mass component to vibrate. Therefore, a structural design of the elastic component may affect a vibration feature of the vibration device. In some embodiments, the one or more elastic components may be designed in a curved shape to increase a length of the one or more elastic components to meet needs of the one or more elastic components for an elasticity coefficient, thereby reducing the elasticity coefficient of the elastic component. In this arrangement, if the shape of the one or more elastic components have a rotational or asymmetric configuration, the mass component of the vibration device may produce a rotational mode during vibrating, which may affect an output of the vibration device (which may appear as a resonant valley in the frequency response curve), and thereby affecting a vibration performance of the vibration device. Therefore, a structure of the elastic component may be reasonably designed to ensure the vibration performance of the vibration device.

In some embodiments, a plurality of elastic components connecting the mass component and the piezoelectric component may be distributed along a circumference of the ring of the piezoelectric component. In some embodiments, the plurality of elastic components may be symmetrically distributed in a circumferential direction of the piezoelectric component, so that a symmetry of the plurality of elastic components (e.g., opposite rotation of the elastic components) may be configured to invert a rotational mode to phase out the rotational mode in a situation where the vibration device may produce the rotational mode, thereby reducing or reducing resonant valleys produced by the rotational mode.

In some embodiments, a shape of each of the one or more elastic components may include at least one of a folded shape, an S-shape, a spline curve shape, an arc shape, and a straight-line shape. In some embodiments, the one or more elastic components may have different bending segments and bending directions when the one or more elastic components is a different shape. In some embodiments, the one or more elastic components may be connected on both sides of a reference line to form sub-segments alternately using the line connecting the two ends of the elastic component as a reference line, and segments formed by a plurality of sub-segments with a same alternating rule may be bending segments of the one or more elastic component. In some embodiments, a bending direction may be a direction expressing an alternating rule of the plurality of subsegments on both sides of the reference line. If the shape of the one or more elastic components is a bending line, for example, a bending line may be bent toward the first side of the reference line, then toward the second side of the reference line, and then toward the first side, and so on, then a direction where the bending line starts to bend may be recorded as the bending direction of a bending line, and the bending segment of the bending line segment ends when the alternating rule is broken.

FIG. 12 is a structure diagram illustrating an exemplary elastic component according to some embodiments of the present disclosure. In some embodiments, each elastic component of one or more elastic components 1200 may have a plurality of bending segments, and adjacent bending segments of the plurality of bending segments may have opposite bending directions. For example, the each elastic component 1200 of the plurality of elastic components 1200 in FIG. 12 may include two bending segments, a first bending segment 1210 and a second bending segment 1220. The first bending segment 1210 and the second bending segment 1220 may be connected end to end to form the one or more elastic components 1200. A bending direction of the first bending segment 1210 may be a first direction, and a bending direction of the second bending segment 1220 may be a second direction. The first direction and the second direction may be opposite relative to a reference line (as shown by a dashed line in FIG. 12). In some embodiments, the first direction may be a counterclockwise direction in a projection plane along the axial direction of the piezoelectric component relative to a center of a projected shape of the elastic component, and the second direction may be a clockwise direction in a projection plane along the axial direction of the piezoelectric component relative to the center of the projected shape of the elastic component.

The rotational modes of the adj acent bending segments may be cancelled out in opposite phases during vibrating by arranging the bending directions of adjacent bending segments in the plurality of bending segments of the elastic component 1200 to be opposite, thereby reducing or eliminating the resonant valleys produced by the rotational modes.

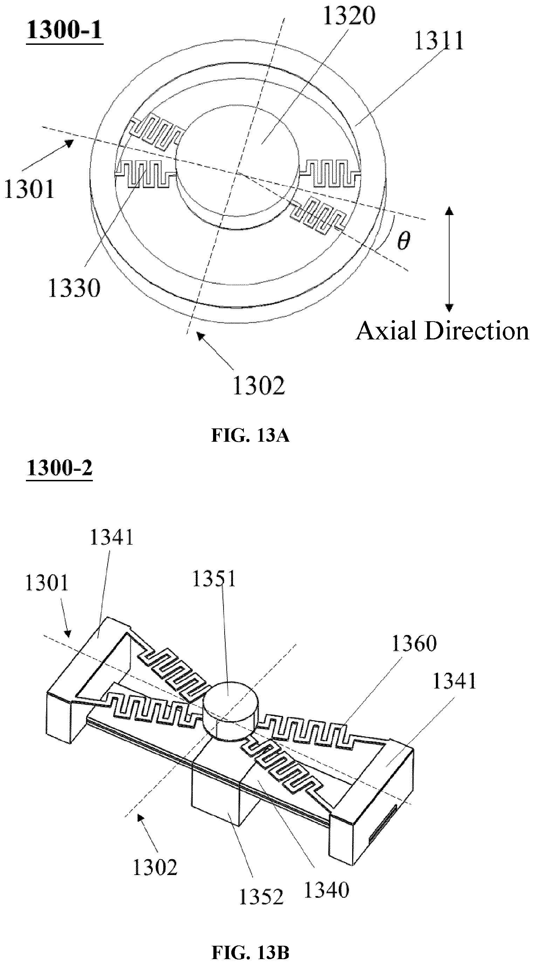

FIG. 13A is a structure diagram illustrating an exemplary vibration device according to some embodiments of the present disclosure. A structure of a vibration device 1300-1 shown in FIG. 13A may be substantially the same as a structure of a vibration device 200 shown in FIG. 2, and a difference is in the structure of the one or more elastic components.

As shown in FIG. 13A, in some embodiments, a plurality of elastic components 1330 may be located in a same plane perpendicular to an axial direction of the first piezoelectric component 1311. For example, the plurality elastic component 1330 may be a vibration-transmitting sheet structure or a vibration-transmitting rod structure, with the plurality of vibration-transmitting sheets located in the same plane that is perpendicular to the axial direction of the ring structure. In some embodiments, the plurality of elastic components 1330 may be arranged in a certain manner such that a projection of the plurality of elastic components 1330 that are arranged along the axial direction of the first piezoelectric component 1311 may have at least two axes of symmetry perpendicular to each other.

In some embodiments, a count of the plurality of elastic components 1330 connecting the mass component 1320 and the first piezoelectric component 1311 may be an even number (e.g., four, eight, etc.). As shown in FIG. 13A, in some embodiments, the count of the plurality of elastic components 1330 connecting the mass component 1320 and the first piezoelectric component 1311 may be four. The four elastic components are arranged to form an X-shape. Bending directions of adjacent elastic components among the four elastic components may be opposite, and bending directions of opposite elastic components may be the same. When the four elastic components 1330 are arranged in an X-shape, projections of the 4 elastic components 1330 along the axial direction of the first piezoelectric component 1311 may have two first axes of symmetry 1301 and two second axes of symmetry 1302 that are perpendicular to each other.

In some embodiments, an angle may be formed between an individual elastic component of the plurality of elastic components and an axis of symmetry (e.g., a first axis of symmetry 1301 or a second axis of symmetry 1302) in a plurality of X-shaped elastic component 1330. For example, an angle $\theta$ may be formed between the elastic component and the first axis of symmetry 1301. A rolling mode of the vibration device may be controlled along different axes of symmetry during vibrating by regulating angles of the angle $\theta$. In some embodiments, to minimize the rolling mode of the vibration device when vibrating, an angle range of the angle $\theta$ may be within a range of 10° - 30°. In some embodiments, to minimize the rolling mode of the vibration device when vibrating, an angle range of the angle $\theta$ may be within a range of 30°-60°. In some embodiments, to minimize the rolling mode of the vibration device when vibrating, an angle range of the angle $\theta$ may be within a range of 60°-80°.

The structure and connection of the elastic component 1330 shown in FIG. 13A is not only applicable to the piezoelectric component of the aforementioned ring structure, but also to the piezoelectric component of other configurations. For example, FIG. 13B is a structure diagram illustrating an exemplary vibration device according to some embodiments of the present disclosure. A vibration device 1300-2 shown in FIG. 13B may include a piezoelectric component 1340, a first mass component 1351, a second mass component 1352, a connector 1341, and one or more elastic components 1360. In some embodiments, the piezoelectric component 1340 may be constructed as a piezoelectric beam structure, and the second mass component 1352 may be connected to middle of the piezoelectric beam. In some embodiments, one surface or a set of opposing surfaces of the piezoelectric beam may have a piezoelectric sheet (the one or the set of surfaces is also referred to as a piezoelectric surface) affixed thereto, and the piezoelectric sheet may be telescopically deformed based on an electrical signal such that the piezoelectric beam may produce a vibration perpendicular to the piezoelectric surface based on the electrical signal. In some embodiments, the piezoelectric beam may be provided with connectors 1341 at both ends of the piezoelectric beam, and the piezoelectric beam may be connected to one end of the plurality of elastic components 1360 through the connector 1341 at both ends. In some embodiments, another end of the plurality of elastic components 1360 may be connected to the first mass component 1351. In some embodiments, the plurality of elastic components 1360 may be distributed along a circumferential direction of the first mass component 1351. In some embodiments, the plurality of elastic components 1360 may be located in a same plane, the plane where the elastic components 1360 are located is parallel to a piezoelectric plane of the piezoelectric beam. A shape structure of the plurality of elastic components 1360 may be the same as the shape structure of the plurality of elastic component 1330 shown in FIG. 13A. For example, a count of the plurality of elastic components 1360 may be four, and the four elastic components are arranged to form an X-shape. The four elastic components 1330 may have the axis of symmetry 1301 and the axis of symmetry 1302 such that the bending directions of adjacent elastic components in the four elastic components 1330 may be opposite.

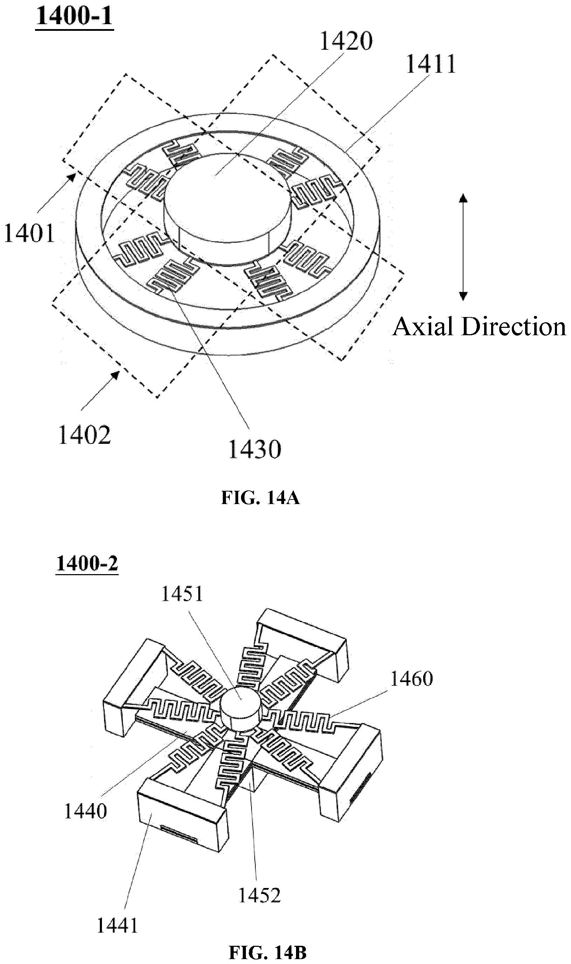

FIG. 14A is a structure diagram illustrating an exemplary vibration device according to some embodiments of the present disclosure. A structure of the vibration device 1400-1 shown in FIG. 14A is substantially the same as a structure of the vibration device 1300-1 shown in FIG. 13A, and differences are in a count and a structure of the one or more elastic components.

As shown in FIG. 14A, in some embodiments, a count of plurality of elastic components 1430 connecting the mass component 1420 and the first piezoelectric component 1411 may be eight, and the eight elastic components may form a double X-shape. In particular, four of the eight elastic components may constitute a first X-shaped 1401 and the remaining four elastic components constitute a second X-shaped 1402, and the first X-shaped 1401 and the second X-shaped 1402 form a double X-shaped structure of the plurality of elastic components 1430. In some embodiments, the double X-shaped structure formed by the plurality of elastic components 1430 may be a parallel double X-shape, a perpendicular double X-shape (as shown in FIG. 14A), or a shape of reverse symmetrical distribution in other forms. A parallel/perpendicular double X-shape may be one where the two axes of symmetry of the first X-shape 1401 are correspondingly parallel/perpendicular to the two axes of symmetry of the second X-shape 1402, respectively.

FIG. 14B is a structure diagram illustrating an exemplary vibration device according to some embodiments of the present disclosure. A structure of the vibration device 1400-2 shown in FIG. 14B is substantially the same as a structure of the vibration device 1300-2 shown in FIG. 13B, and differences are in a count of the piezoelectric beams, a count of the plurality of elastic components, and the structure.

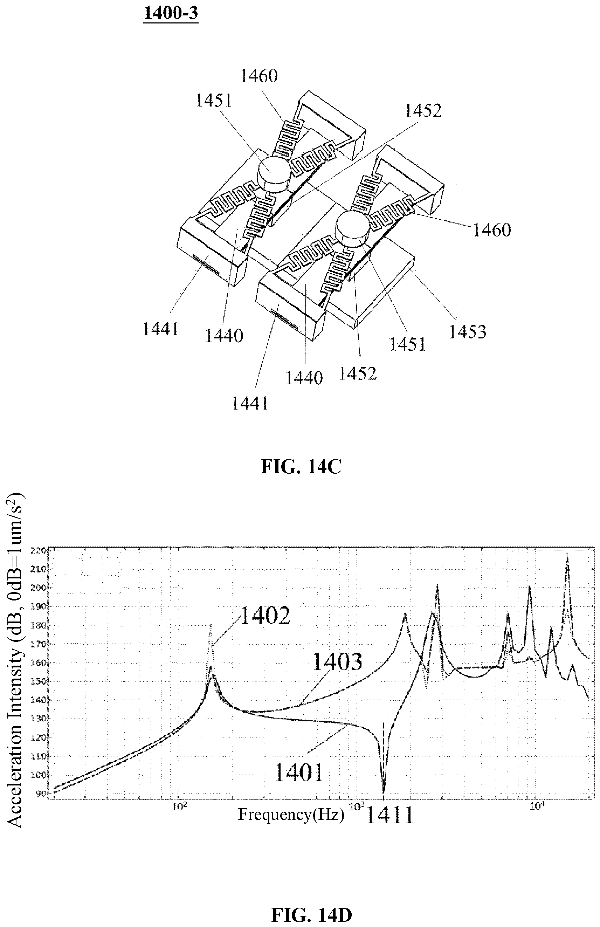

As shown in FIG. 14B, in some embodiments, a count of the plurality of elastic components 1460 connecting a mass component 1450 and a piezoelectric component 1440 may be eight. The eight elastic components 1460 may be distributed along a circumference of a first mass component 1451. In some embodiments, the eight elastic components may form a double X shape. In particular, the four of the eight elastic components may form a first X-shape, and the remaining four elastic components form a second X-shape, and the first X-shape and the second X-shape form a double X-shaped structure of the plurality of elastic components 1460. In some embodiments, the double X-shaped structure formed by the plurality of elastic components 1460 may be a parallel double X-shape (as shown in FIG. 14C), a perpendicular double X-shape (as shown in FIG. 14B), or a shape of reverse symmetrical distribution in other forms.

As shown in FIG. 14B, when the double X-shaped structure formed by the plurality of elastic components 1460 is a vertical double X-shaped structure, the four elastic components forming the first X-shape may be connected to a same piezoelectric component in each piezoelectric component 1440 of the two piezoelectric components 1440 (e.g., a piezoelectric beam structure) through the connector 1441, respectively. The four elastic components forming the second X-shape may be connected to the other piezoelectric component. The two piezoelectric components in the same plane may be perpendicular to each other. The two piezoelectric components 1440 may be connected to the second mass component 1452 at the same time.

FIG. 14C is a schematic diagram illustrating an exemplary structure of a vibration device according to some embodiments of the present disclosure. As shown in FIG. 14C, a double X-shaped structure formed by a plurality of elastic components 1460 is a parallel double X-shaped structure. In FIG. 14C, a connection manner of the plurality of elastic components of the vibration device 1400-3 are the same as the connection manner in FIG. 14B. A difference is that the four elastic components 1460 forming the first X-shape may be connected to one piezoelectric component 1440 (e.g., a piezoelectric beam structure) through a connector 1441, and the four elastic components 1460 forming the second X-shape may be connected to another piezoelectric component 1440 (e.g., a piezoelectric beam structure) through a connector 1441. The two piezoelectric components 1440 in the same plane may be arranged parallel to each other. The four elastic components 1460 forming the first X-shape and the four elastic components 1460 forming the second X-shape may be also connected to the first mass component 1451, respectively. In some embodiments, the first mass component 1451 may be one, or alternatively, the first mass component 1451 may be more than one. The plurality of first mass components 1451 may be interconnected through a rigid connector (not shown in the figures). The two piezoelectric components 1440 may be each connected to the second mass component 1452. In some embodiments, the second mass component 1452 may be one, or alternatively, the second mass component 1452 may be more than one. The plurality of second mass components 1452 may be interconnected through a rigid connector 1453.

In some embodiments, the vibration performance of the vibration device may vary when the shape structure of the elastic component varies. The greater the degree of inverse symmetry of the elastic component, the less rotational modes produced by the vibration of the elastic component, and the better the vibration performance of the vibration device. FIG. 14D is a schematic diagram illustrating a frequency response curve of a vibration device according to some embodiments of the present disclosure. In particular, a curve 1401 may denote a frequency response curve of the vibration device when the elastic component is a single X-shaped (e.g., a vibration device 1300-2), a curve 1402 may denote a frequency response curve of the vibration device when the elastic component is a parallel double X-shaped (e.g., a vibration device 1400-3), and a curve 1403 may denote a frequency response curve of the vibration device when the elastic component is a non-parallel double X-shaped (e.g., vibration device 1400-1 or 1400-2). Combining curve 1401, curve 1402 and curve 1403, a frequency response of the vibration device is good when the configuration of the elastic component is single X-shaped, parallel double X-shaped and other types of double X-shaped. It should be noted that when the elastic component is single X-shaped, the curve 1401 produces a resonant valley close to 1411 Hz, which is not produced by the rotational mode of the elastic component, but is caused by the mass component connected to the piezoelectric component and a vibration system formed by the piezoelectric component that absorbs a vibration of an output end. For example, in conjunction with FIG. 13B, the resonant valley may be caused by a second mass component 1352 and a vibration system formed by a piezoelectric beam 1340 absorbing a vibration of a first mass component 1351.

In some embodiments, the elastic component may also be arranged in a double-layer structure. The double-layer elastic component may be distributed up and down along the axial direction of the ring structure. In some embodiments, the elastic component may include a first elastic component and a second elastic component arranged along the axial direction of the ring structure. The bending directions of the first elastic component and the second elastic component may be correspondingly opposite. For example, the bending direction of the plurality of bending segments of the first elastic component and the bending directions of the plurality of bending segments of the second elastic component may be correspondingly opposite, respectively.

In some embodiments, a shape of the double-layered elastic component may be any one of a double-layered bending shape, a double-layered S-shape, a double-layered spline shape, or a double-layered arc shape. In some embodiments, a first layer of a double-layered elastic component may be a plurality of bending-shaped elastic components along the first direction, and a second layer may be a plurality of bending-shaped elastic components along the second direction. The first direction and the second direction are opposite relative to a reference line of the elastic component.

In some embodiments, when a structure of the elastic component is a double-layer structure, the bending directions of adjacent bending segments may be opposite in the plurality of bending segments included in each elastic component of the plurality of elastic components located in the same layer. At the same time, the bending directions of two elastic components located at different levels that are arranged opposite along the axial direction of the ring structure may be opposite.

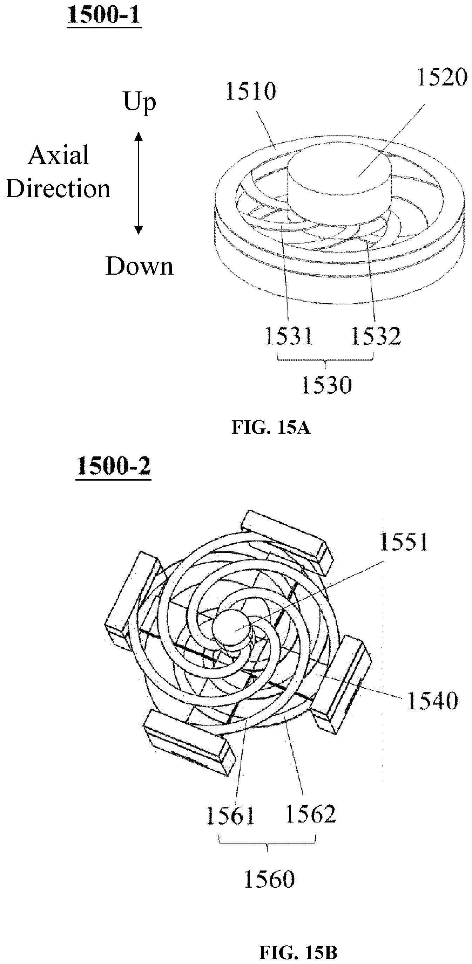

FIG. 15A is a structure diagram illustrating an exemplary vibration device according to some embodiments of the present disclosure. A structure of a vibration device 1500-1 shown in FIG. 15A is substantially the same as a structure of a vibration device 200 shown in FIG. 2, and a difference is in the structure of the one or more elastic components.

As shown in FIG. 15A, one or more elastic components 1530 may include a first spiral structure 1531 and a second spiral structure 1532. The first spiral structure 1531 and the second spiral structure 1532 may connect a mass component 1520 and one or more piezoelectric components 1510, respectively. In some embodiments, the first spiral structure 1531 and the second spiral structure 1532 may be aligned up and down along an axial direction of the piezoelectric component 1510. The first spiral structure 1531 may be connected to the piezoelectric component 1510 at a location closer to one side of the piezoelectric component 1510 that is closer to the mass component 1520. The second spiral structure 1532 may be connected to the piezoelectric component 1510 on one side of the piezoelectric component 1510 that is further away from the mass component 1520.

In some embodiments, axes of the first spiral structure 1531 and the second spiral structure 1532 may be the same and spiral directions are opposite. A spiral direction may be a direction where the spiral structure rotates about the axis thereof. In some embodiments, at least two elastic components 130 may be rotated in opposite directions along a same axis to form a first spiral structure 1531 and a second spiral structure 1532 in opposite spiral directions.

In some embodiments, the rotation amplitude of the elastic component 1530 during the vibration of the vibration device 1500 may be reduced by arranging the one or more elastic components 1530 in a double-layer spiral structure. At the same time, a double-layer spiral structure may also increase an elasticity coefficient of the elastic component 1530, so that a first resonant peak produced by a resonant of the elastic component 1530 and the mass component 1520 moves rightwards (i.e., to a higher frequency) to satisfy a vibration performance of the vibration device 1500-1.

FIG. 15B is a structure diagram illustrating an exemplary vibration device according to some embodiments of the present disclosure. A double spiral structure of the elastic component 1530 shown in FIG. 15A may also be applied to a vibration device 1500-2 shown in FIG. 15B. A structure of the vibration device 1500-2 in FIG. 15B is substantially the same as a structure of a vibration device 1400-2 in FIG. 14B, and a difference is in the structure of the one or more elastic components.

As shown in FIG. 15B, in some embodiments, an elastic component 1560 may include a first spiral structure 1561 and a second spiral structure 1562. The first spiral structure 1561 and the second spiral structure 1562 may be arranged up and down along a thickness direction of the first mass component 1551. The first spiral structure 1561 and the second spiral structure 1562 may be connected to the first mass component 1551 and a plurality of piezoelectric components 1540, respectively. Spiral directions of the first spiral structure 1561 and the second spiral structure 1562 are opposite.

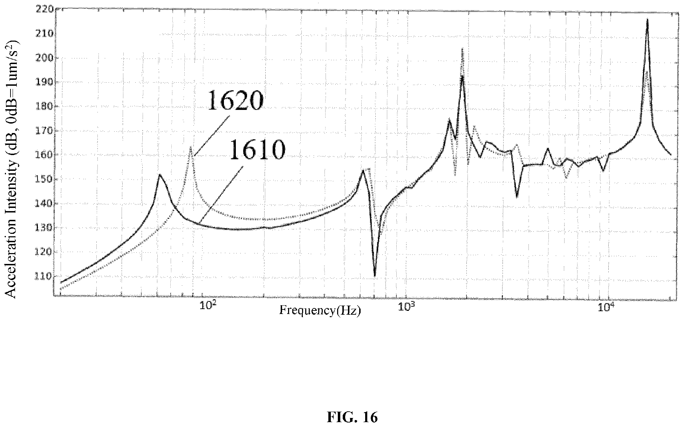

In some embodiments, when the elastic component is a spiral structure, a vibration performance of a corresponding vibration device may be different when counts of layers of the spiral structure are different. In some embodiments, an inverse symmetry of the double spiral structure may be higher than an inverse symmetry of the single spiral structure, so that a vibration performance of a vibration device in which an elastic component is a double spiral structure may be better than a vibration performance of the vibration device in which an elastic component is a single spiral structure. FIG. 16 is a schematic diagram illustrating an exemplary frequency response curve of a vibration device according to some embodiments of the present disclosure. A curve 1610 may denote a frequency response curve of a vibration device in which the elastic component is a single-layer spiral structure, and a curve 1620 may denote a frequency response curve of a vibration device in which an elastic component is a double-layer spiral structure. Referring to curve 1610 and curve 1620, compared to the single-layer spiral structure of the elastic component, a peak of the resonant valley formed by the frequency response curve 1620 of the vibration device in which the elastic component is a double-layer spiral structure significantly increases.

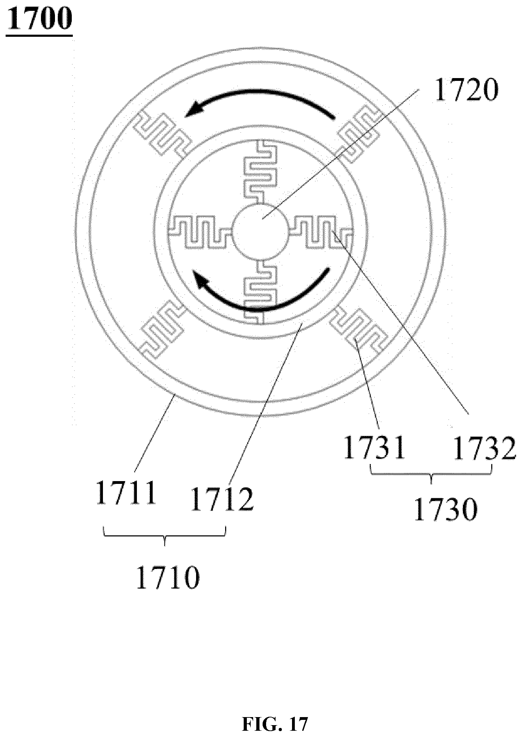

FIG. 17 is a schematic diagram illustrating an exemplary structure of a vibration device according to some embodiments of the present disclosure. As shown in FIG. 17, a vibration device 1700 may include one or more piezoelectric components 1710, a mass component 1720, and one or more elastic components 1730. The one or more piezoelectric components 1710 may include a first piezoelectric component 1711 and a second piezoelectric component 1712. The second piezoelectric component 1712 may be located on an inner side of a first ring structure of the first piezoelectric component 1711. The mass component 1720 may be located on an inside of a second ring structure of the second piezoelectric component 1712.

In some embodiments, the one or more elastic components 1730 may include one or more inner ring elastic components 1732 and one or more outer ring elastic components 1731. In some embodiments, the one or more inner ring elastic components 1732 and the one or more outer ring elastic components 1731 may be bent in opposite directions. For example, shapes of the inner ring elastic component 1732 and the outer ring elastic component 1731 may be S-shape, and bending direction of S-shaped inner ring elastic component 1732 and S-shaped outer ring elastic component 1731 may be opposite.

In some embodiments, when the bending direction of the inner ring elastic component 1732 is opposite to the bending direction of the outer ring elastic component 1731, a rotational mode produced by the inner ring elastic component 1732 and a rotational mode produced by the outer ring elastic component 1731 during vibrating of the vibration device 1700 may be opposite, so that the rotational mode produced by the inner ring elastic component 1732 and the rotational mode produced by the outer ring elastic component 1731 may cancel out (or weaken) each other, thereby overall reducing a rotational mode of the vibration device 1700 during vibrating.

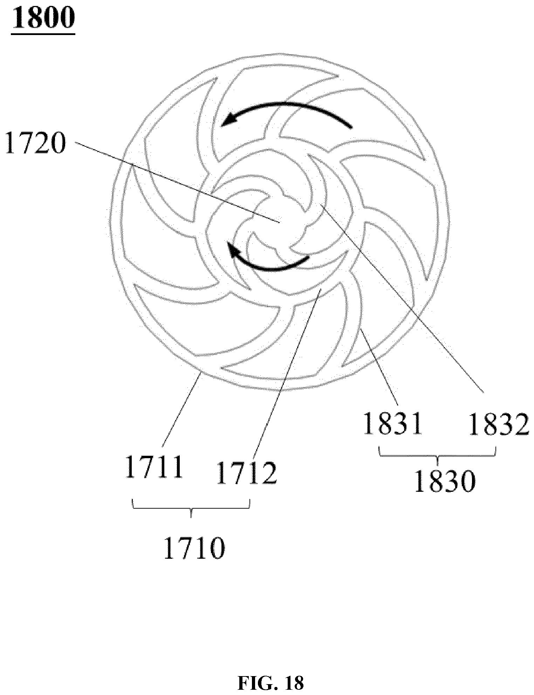

FIG. 18 is a structure diagram illustrating an exemplary vibration device according to some embodiments of the present disclosure. A structure of a vibration device 1800 shown in FIG. 18 is substantially the same as a structure of a vibration device 1700 shown in FIG. 17, the difference is in a shape of the elastic component. A shape of the one or more elastic components 1830 of the vibration device 1800 is arcuate. Bending directions of an arc of an inner ring elastic component 1832 and an arc of an outer ring elastic component 1831 are opposite.

In some embodiments, when the one or more elastic components include one or more inner ring elastic components and one or more outer ring elastic components, a shape of the inner/outer ring elastic component may not be limited to S-shaped and curved, but may also be other shapes, for example, bending-shaped or spline-shaped, etc.

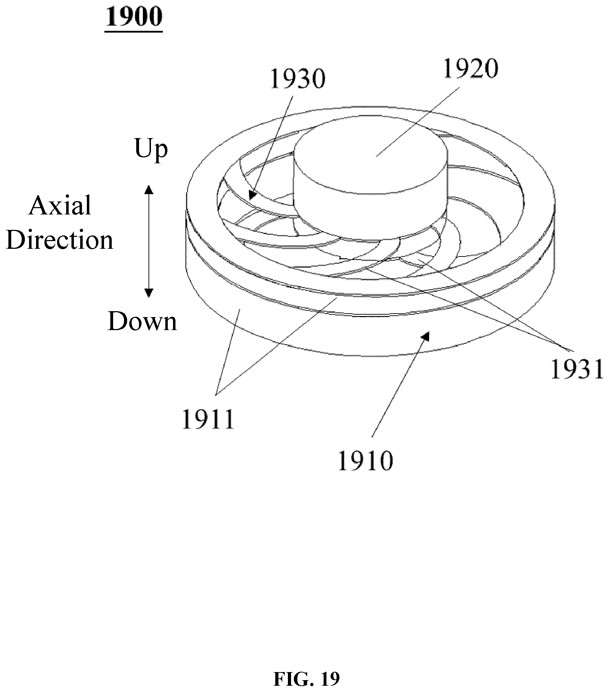

FIG. 19 is a structure diagram illustrating an exemplary vibration device according to some embodiments of the present disclosure. As shown in FIG. 19, a vibration device 1900 may include one or more piezoelectric components 1910, a mass component 1920, and one or more elastic components 1930. In some embodiments, the one or more piezoelectric components 1910 may include two first piezoelectric components 1911, and the two first piezoelectric components 1911 may be distributed up and down along an axial direction and connected to each other. The two first piezoelectric components 1911 may be distributed up and down along the axial direction to form a double-layered single ring structure of the piezoelectric component 1910.

In some embodiments, the mass component 1920 may be connected to each piezoelectric component 1911 of the two first piezoelectric components 1911 through the one or more elastic components 1930. In some embodiments, the one or more elastic components 1930 may be arranged in a double layer. The double layer elastic components 1930 may include two layers of the first elastic components 1931. The two layers may be arranged up and down along an axial direction of the piezoelectric component 1910. In some embodiments, the two layers of first elastic components 1931 may be connected to a circumferential direction of the two first piezoelectric components 1911, respectively. The mass component 1920 may be connected to each piezoelectric component 1911 of the two piezoelectric components 1911 through the two layers of first elastic components 1931, correspondingly. In some embodiments, bending directions of the two layers of the first elastic components 1931 may be opposite.

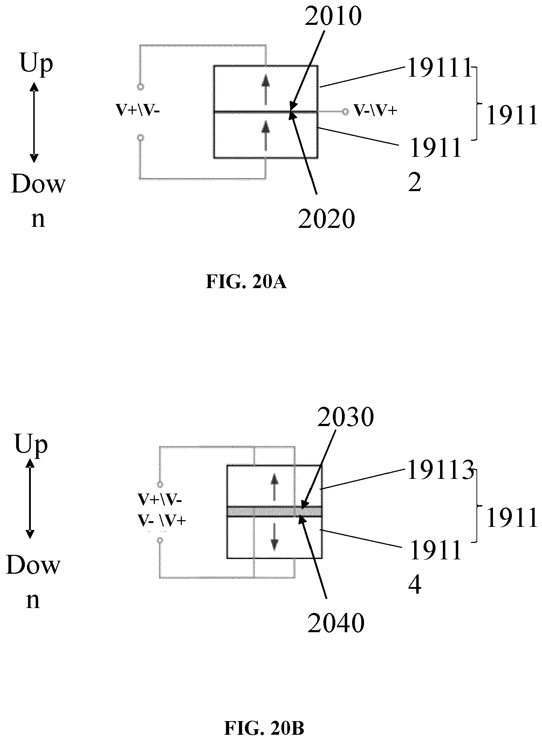

In some embodiments, when a count of first piezoelectric components 1911 is two, displacement changes of the two first piezoelectric components 1911 along the axial direction during vibrating may be opposite. That is, a displacement of one first piezoelectric component 1911 of the two first piezoelectric components 1911 becomes greater along the axial direction during vibrating (i.e., elongated), and a displacement of another piezoelectric component 1911 of the two first piezoelectric components 1911 becomes less along the axial direction during vibrating (i.e., contracted). In some embodiments, a displacement change of the first piezoelectric component 1911 along the axial direction during vibrating may be modulated through a polarization direction of the first piezoelectric component 1911 and an electrode polarity of an electrical signal, which may be found in relative descriptions in FIG. 20A and FIG. 20B of the present disclosure.

In some embodiments, a count of the plurality of first piezoelectric components 1911 included in the piezoelectric component 1910 may be more than one (e.g., four, six, eight, etc.). The plurality of first piezoelectric components 1911 may be connected sequentially along the axial direction, and the mass components 1920 may be connected to each first piezoelectric component 1911 of the plurality of first piezoelectric components 1911 through the plurality of elastic components 1930 (e.g., divided into multiple layers), respectively. In some embodiments, a count of the mass components 1920 may also be more than one, and each mass component 1920 of the plurality of mass components 1920 may be connected to one first piezoelectric component 1911 through the plurality of elastic components 1930.

FIG. 20A is an exemplary circuit diagram illustrating a first piezoelectric component according to some embodiments of the present disclosure. As shown in FIG. 20A, polarities of a connecting surface of two first piezoelectric components 1911 may be the same, and electrode polarities of an electrical signal on the connecting surface may be the same. For a purpose of description, the two first piezoelectric components 1911 may be noted as an upper piezoelectric component 19111 and a lower piezoelectric component 19112, respectively. In some embodiments, the upper piezoelectric component 19111 may have an upper connection surface 2010 and the lower piezoelectric component 19112 may have a lower connection surface 2020 when the upper piezoelectric component 19111 is connected to the lower piezoelectric component 19112. In some embodiments, when a polarization direction of the upper piezoelectric component 19111 is the same as a polarization direction of the lower piezoelectric component 19112 (as shown by an arrow in FIG. 20A), an electrode polarity (e.g., positive or negative) of an electrical signal connected to the upper connection surface 2010 may be the same as an electrode polarity of an electrical signal connected to a lower connection surface 2020. In this arrangement, a direction of an electrical potential inside the upper piezoelectric component 19111 may be opposite to a direction of an electrical potential inside the lower piezoelectric component 19112.

The upper piezoelectric component 19111 and the lower piezoelectric component 19112 may produce displacements in opposite directions by arranging the upper piezoelectric component 19111 and the lower piezoelectric component 19112 to have a same polarization direction, when the upper piezoelectric component 19111 and the lower piezoelectric component 19112 are connected to a potential (or the electrical signal) in opposite directions.

FIG. 20B is an exemplary circuit diagram illustrating a first piezoelectric component according to some embodiments of the present disclosure. As shown in FIG. 20B, the polarities of connecting surfaces of the two first piezoelectric components may be opposite, and the electrode polarities of an electrical signal on the connecting surface may be opposite. In some embodiments, when an upper piezoelectric component 19113 is connected to a lower piezoelectric component 19114, the upper piezoelectric component 19113 may have an upper connection surface 2030 and the lower piezoelectric component 19114 may have a lower connection surface 2040. When a polarization direction of the upper piezoelectric component 19112 is opposite to a polarization direction of the lower piezoelectric component 19114 (as shown by the arrow in FIG. 20B), an electrode polarity of an electrical signal (e.g., positive or negative) connected to the upper connection surface 2030 may be opposite to the electrode polarity of the electrical signal connected to the lower connection surface 2040. In this arrangement, a direction of an electrical potential inside the upper piezoelectric component 19111 may be the same as a direction of an electrical potential inside the lower piezoelectric component 19112.

The upper piezoelectric component 19113 and the lower piezoelectric component 19114 may produce displacements in opposite directions by arranging the polarization direction of the upper piezoelectric component 19113 and the lower piezoelectric component 19114 to be opposite, when the upper piezoelectric component 19113 and the lower piezoelectric component 19114 are connected to a potential (or electrical signal) in the same direction.

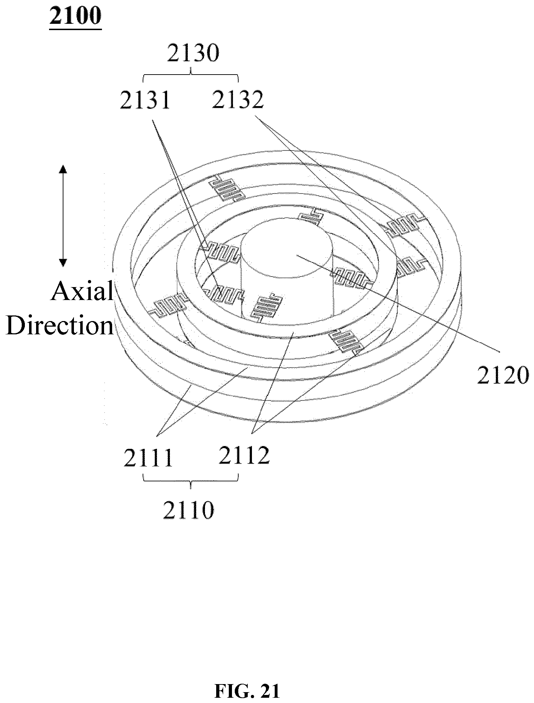

FIG. 21 is a structure diagram illustrating an exemplary vibration device according to some embodiments of the present disclosure. A structure of a vibration device 2100 shown in FIG. 21 is similar to a structure of a vibration device 500 shown in FIG. 5, a difference is that a structure of the piezoelectric component is different. The piezoelectric component 510 of the vibration device 500 may be a single-layer bi-ring structure, and a piezoelectric component 2110 of the vibration device 2100 may be a double-layer bi-ring structure.

As shown in FIG. 21, in some embodiments, the one or more piezoelectric components 2110 may include two first piezoelectric components 2111 and two second piezoelectric components 2112. The two first piezoelectric components 2111 may be distributed up and down and connected to each other along the axial direction, and the two second piezoelectric components 2112 located on an inner side of a first ring structure may be distributed up and down and connected to each other along the axial direction. Axes of the two second piezoelectric components 2112 may coincide with axes of the two first piezoelectric components 2111, and projections of the two second piezoelectric components 2112 along the axial direction may be located inside a projection of a first ring structure of the two first piezoelectric components 2111 along the axial direction.

In some embodiments, the two second piezoelectric components 2112 may be connected to the two first piezoelectric components 2111 through at least one elastic component of the one or more elastic components. In some embodiments, the elastic component may include an outer ring elastic component 2132, and the outer ring elastic component 2132 may be located between the first ring structure and the second ring structure. The outer ring elastic component 2132 may include two elastic components, and the two first piezoelectric components 2111 and the two second piezoelectric components 2112 may be connected through the two elastic components in the outer ring elastic component 2132, respectively. In some embodiments, the outer ring elastic component 2132 may also have a certain thickness along an axial direction of the second ring structure, and the two first piezoelectric components 2111 and the two second piezoelectric components 2112 may be connected through one outer ring elastic component 2132.

In some embodiments, as shown in FIG. 21, the mass component 2120 may be located on an inner side of a second ring structure of the second piezoelectric component 2112 (as shown in FIG. 21). A projection of the mass component 2120 along the axial direction is located inside a projection of the second piezoelectric component 2122 along the axial direction. The mass component 2120 may be connected to each second piezoelectric component 2112 of the two second piezoelectric components 2112 through at least one elastic component of the one or more elastic components 2130. For example, the one or more elastic components 2130 may include an inner ring elastic component 2131. The inner ring elastic component 2131 may be located between the second ring structure and the mass component 2120. The inner ring elastic component 2131 may include two elastic components arranged in the axial direction, and the mass component 2120 may be connected to each second piezoelectric component 2112 of the two second piezoelectric components 2112 through the two elastic components in the inner ring elastic component 2131. In some embodiments, the inner ring elastic component 2131 may also have a certain thickness along the axial direction of the first ring structure, and the mass component 2120 and the two second piezoelectric components 2112 may be connected through the inner ring elastic component 2131.

In some embodiments, when the mass component 2120 is located on the inner side of the second piezoelectric component 2112, one end of the first piezoelectric component 2111 along the axial direction may be fixed and another end of the first piezoelectric component 2111 may be connected to the second piezoelectric component 2112 through the outer ring elastic component 2132. For example, the outer ring elastic component 2132 may also include two elastic components arranged along the axial direction, and the two first piezoelectric components 2111 may be connected to the two second piezoelectric components 2112 through the two elastic components in the outer ring elastic component 2132, respectively. In this case, the second piezoelectric component 2112 may be configured as a piezoelectric free ring and the first piezoelectric component 2111 may be configured as a piezoelectric fixed ring.

In some embodiments, the mass component 2120 may also be located outside the first ring structure of the first piezoelectric component 2111. The projection of the mass component 2120 along the axial direction may be located outside of a projection of the first piezoelectric component 2121 along the axial direction. The mass component 2120 may be connected to each first piezoelectric component 2111 of the two first piezoelectric components 2111 through the at least one elastic component of the one or more elastic components 2130, respectively. For example, the mass component 2120 may be connected to each first piezoelectric component 2111 of the two first piezoelectric components 2111 through two elastic components of the outer ring elastic components 2132.

In some embodiments, when the mass component 2120 is located on an outer side of the first piezoelectric component 2111, the second piezoelectric component 2112 may be fixed at one end along the axial direction and connected to the first piezoelectric component 2111 at another end through the inner ring elastic component 2131. In this case, the second piezoelectric component 2112 may be configured as a piezoelectric fixed ring and the first piezoelectric component 2111 may be configured as a piezoelectric free ring.

In some embodiments, the mass component 2120 may also be located between the first ring structure of the first piezoelectric component 2111 and the second ring structure of the second piezoelectric component 2112. The projection of the mass component 2120 along the axial direction may be located between a projection of the first piezoelectric component 2111 and the second piezoelectric component 2112 along the axial direction. The mass component 2120 may be connected to each first piezoelectric component 2111 of the two first piezoelectric components 2111 and the two second piezoelectric components 2112 through one or more elastic components 2130, respectively. For example, the mass component 2120 may be connected to each of the two first piezoelectric components 2111 through the outer ring elastic component 2132, and the mass component 2120 may be connected to each second piezoelectric component 2112 of the two second piezoelectric components 2112 through the inner ring elastic component 2131, respectively.

In some embodiments, the first piezoelectric component 2111 or the second piezoelectric component 2112 may have a fixed end along the axial direction when the mass component 2120 is located between the second piezoelectric component 2112 and the first piezoelectric component 2111. In this case, one of the first piezoelectric component 2111 and the second piezoelectric component 2112 may be configured as a piezoelectric free ring and another one may be configured as a piezoelectric fixed ring.

It should be noted that when the piezoelectric component 2110 is a double-layer structure, the piezoelectric component 2110 may also not have the fixed end along the axial direction, thereby ensuring the vibration device 2100 to have better ease of use in bone-conducting headsets where it is difficult to find a strict fixed boundary.

In some embodiments, the mass component 2120 and the second piezoelectric component 2112 may form an integral mass by arranging the first piezoelectric component 2111 and the second piezoelectric component 2112 in the vibration device 2100. Since the integral mass is greater than a mass of the mass component 2120, a first resonant peak of the vibration device 2100 may move to a lower frequency. When the vibration device 2100 is vibrating, a bi-ring structure formed by the first piezoelectric component 2111 and the second piezoelectric component 2112 interconnected through the outer ring elastic component 2132 may resonate to produce a third resonant peak located between the first resonant peak and the second resonant peak. The third resonant peak may be shown in the frequency response curve of the vibration device 2100 as a resonant peak additionally formed and located at a location between the first resonant peak and the second resonant peak. In some embodiments, the third resonant frequency corresponding to the third resonant peak may be located between a first resonant frequency corresponding to the first resonant peak and a second resonant frequency corresponding to the second resonant peak.

It should be noted that when the piezoelectric component 2110 is a double-layer structure, the one or more elastic components may also be a double-layer structure, and bending direction of two layers of the one or more elastic components in the double-layer structure of the elastic component may be opposite. In some embodiments, the piezoelectric component may also be a multi-layer multi-ring structure, for example, a 4-layer 4-ring structure, etc. The multi-layer multi-ring structure of the piezoelectric component is similar to a double-layer bi-ring structure of the piezoelectric component, which will not be described herein.

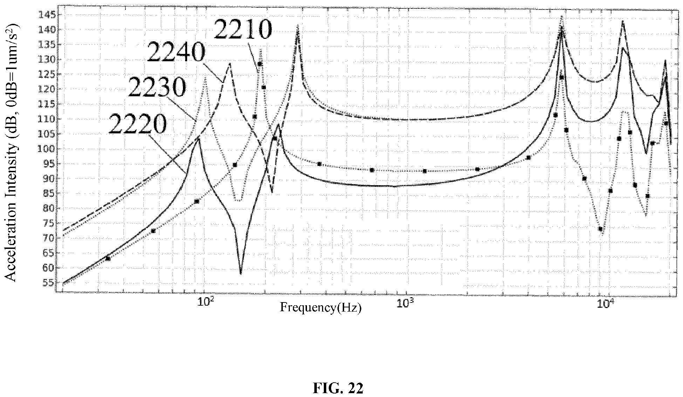

FIG. 22 is a schematic diagram illustrating a frequency response curve of a vibration device according to some embodiments of the present disclosure. A curve 2210 may denote a frequency response curve of a vibration device (e.g., vibration device 1900) when a piezoelectric component is a double-layer single ring structure, and a curve 2220 denotes a frequency response curve of a vibration device (e.g., vibration device 2100) when the piezoelectric component is a single-layer bi-ring structure and the first piezoelectric component has a fixed end along the axial direction. In some embodiments, a third resonant peak other than the first resonant peak and the second resonant peak may be formed in the frequency response curve of the vibration device by providing a piezoelectric free ring in the vibration device. For example, comparing the curve 2210 and the curve 2220, the curve 2220 may form the third resonant peak other than the first resonant peak and the second resonant peak, and a frequency of the third resonant peak is located between a frequency of the first resonant peak and a frequency of the second resonant peak.

Continuously, as shown in FIG. 22, a curve 2230 indicates that a piezoelectric component is a double-layer bi-ring structure and the first piezoelectric component has a frequency response curve of a vibration device with a fixed end along the axial direction, and a curve 2240 indicates that a piezoelectric component is a double-layer bi-ring structure and the piezoelectric component does not have a frequency response curve of a vibration device with a fixed end along the axial direction. In some embodiments, a sensitivity of the vibration device in an audible frequency domain may be improved by providing a piezoelectric component with a double-layer anti-phase vibration structure. For example, comparing the curve 2220 and the curve 2230, the curve 2230 is moved upward overall relative to the curve 2220, and a sensitivity of the curve 2230 is higher than a sensitivity of the curve 2220. In some embodiments, the first piezoelectric component and the second piezoelectric component (and one or more elastic components for connection) together with the mass component to form an overall mass by arranging both the first piezoelectric component and the second piezoelectric component in a free-ring state, thereby causing the low-frequency resonant peak of the vibration device to move rightwards. For example, comparing curves 2230 and 2240, the first resonant peak of curve 2240 is moved rightwards relative to a first resonant peak of the curve 2230, thereby improving a high-frequency performance.

In some embodiments, when the piezoelectric component is arranged in a double-layer structure, structures of two layers of the piezoelectric component may be the same. For example, the piezoelectric component may include two first piezoelectric components arranged sequentially along the axial direction, and both piezoelectric components are ring structures. In some embodiments, when the piezoelectric component is arranged in a double-layer structure, the structures of the two layers of the piezoelectric component may also be different. For example, the piezoelectric component of one layer of the two layers of the piezoelectric component may be a ring structure and another layer of the piezoelectric component is a piezoelectric beam structure.

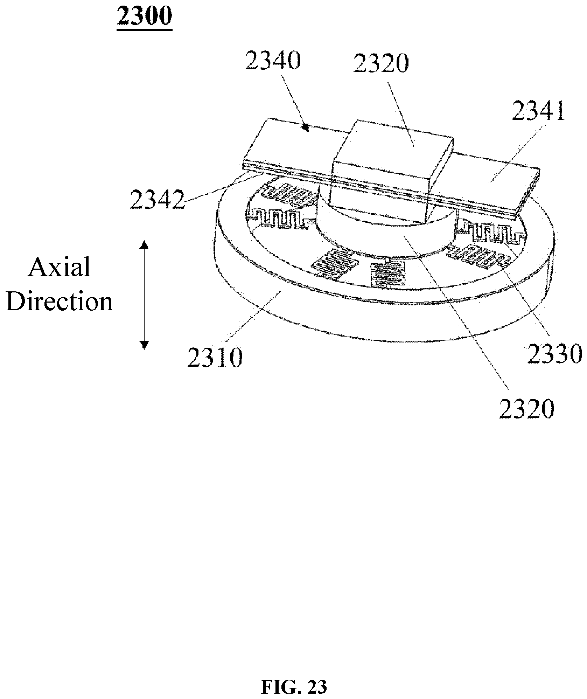

FIG. 23 is a structure diagram illustrating an exemplary vibration device according to some embodiments of the present disclosure. As shown in FIG. 23, a vibration device 2300 may not only include one or more piezoelectric components 2310, a mass component 2320, and one or more elastic components 2330, but also include a piezoelectric beam 2340. The piezoelectric beam 2340 may be configured to produce a vibration based on an electrical signal along the axial direction of the ring structure of the piezoelectric components 2310. In some embodiments, the piezoelectric beam 2340 may be connected to the mass component 2320. In some embodiments, the piezoelectric beam 2340 may be located on one side of the mass component 2320 along the axial direction of the ring structure of the piezoelectric component 2310 away from the piezoelectric component 2310 and connected to the mass component 2320. In some embodiments, the piezoelectric beam 2340 may be a plate-like structure, and a plate-like structure plate (i.e., a surface with the largest area) is arranged parallel to a ring end surface of the ring structure of the piezoelectric component 2310.

In some embodiments, the piezoelectric beam 2340 may include at least one first piezoelectric sheet 2341 and at least one second piezoelectric sheet 2342. The first piezoelectric sheet 2341 and the second piezoelectric sheet 2342 may be arranged on both sides of the piezoelectric beam 2340 along the axial direction of the ring structure of the piezoelectric component 2310, respectively. For example, the first piezoelectric sheet 2341 may be arranged on one side of the piezoelectric beam 2340 along the axial direction away from the piezoelectric component 2310, and the second piezoelectric sheet 2342 may be arranged on one side of the piezoelectric beam 2340 along the axial direction close to the piezoelectric component 2310.

In some embodiments, polarization directions of the first piezoelectric sheet 2341 and the second piezoelectric sheet 2342 may be arranged opposite along the axial direction of the ring structure. That is, a polarization direction of the first piezoelectric sheet 2341 may be opposite to a polarization direction of the second piezoelectric sheet 2342 along the axial direction of the ring structure of the piezoelectric component 2310. Displacement output directions of the first piezoelectric sheet 2341 and the second piezoelectric sheet 2342 may be perpendicular to respective polarization directions. In some embodiments, when the polarization direction of the first piezoelectric sheet 2341 is arranged opposite to the polarization direction of the second piezoelectric sheet 2342, and the first piezoelectric sheet 2341 and the second piezoelectric sheet 2342 are simultaneously connected to a voltage signal in a same direction, the first piezoelectric sheet 2341 and the second piezoelectric sheet 2342 may produce displacements in opposite directions, thereby causing the piezoelectric beam 2340 to vibrate. For example, the first piezoelectric sheet 2341 may contract along a direction perpendicular to the axial direction of the ring structure and the second piezoelectric sheet 2342 may elongate along the direction perpendicular to the axial direction of the ring structure, thereby causing the piezoelectric beam 2340 to produce a vibration along the axial direction of the ring structure. In some embodiments, the piezoelectric beam 2340 may be connected to the mass component 2320 and output the vibration through the mass component 2320. In some embodiments, the piezoelectric beam 2340 may be directly connected to the mass component 2320, such that a resonant peak of the vibration device 2300 includes a high-frequency resonant peak (e.g., in the frequency range of 2 kHz - 20 kHz) produced by resonating through the piezoelectric beam 2340, i.e., the piezoelectric beam 2340 constitutes a high-frequency unit of the vibration device 2300.

In some embodiments, a structure of the one or more elastic components 2330 in the vibration device 2300 may be a double X-shaped structure as shown in FIG. 23, or the structure of the one or more elastic components 2330 in the vibration device 2300 may be another type of the structure with an inverse symmetry, for example, a single X-row, a parallel double X-shape, a spiral structure, etc.

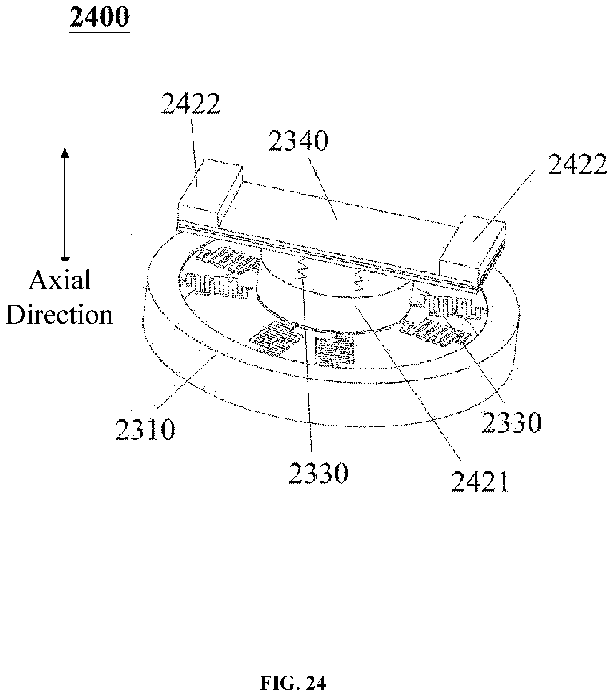

FIG. 24 is a structure diagram illustrating an exemplary vibration device according to some embodiments of the present disclosure. A structure of a vibration device 2400 in FIG. 24 is substantially the same as a structure of a vibration device 2300 in FIG. 23, and differences are in structures and counts of the mass components and connection ways between the mass components and the piezoelectric beam.

As shown in FIG. 24, in some embodiments, the mass component may include a first mass component 2421 and a second mass component 2422. The first mass component 2421 may be connected to middle of the piezoelectric beam 2340 through one or more elastic components 2330. In some embodiments, the first mass component 2421 may also be connected to the one or more piezoelectric components 2310 through the one or more elastic components 2330. The piezoelectric component 2310 may include a ring structure, and a vibration direction of the piezoelectric component 2310 may be parallel to the axial direction of the ring structure. In some embodiments, both ends of the piezoelectric beam 2340 may be connected to a second mass component 2422. A vibration of the vibration device 2400 may be output through the second mass component 2422 at one end of the piezoelectric beam 2340. In some embodiments, a vibration of the vibration device 2400 may also be output through the first mass component 2421. In some embodiments, the first mass component 2421 in the vibration device 2400 may constitute a low-frequency unit of the vibration device 2400 through a connection of the one or more elastic components 2330 and the piezoelectric beam 2340, and the piezoelectric component 2310 with a ring structure may constitute a high-frequency unit of the vibration device 2400.

In some embodiments, the first mass component 2421 may also be connected to other locations of the piezoelectric beam 2340 (e.g., close to an end location of the piezoelectric beam 2340) through the one or more elastic components 2330. In some embodiments, the both ends of the piezoelectric beam 2340 may also be connected to the second mass component 2422 through the one or more elastic components 2330.

Having thus described the basic concepts, it may be rather apparent to those skilled in the art after reading this detailed disclosure that the foregoing detailed disclosure is intended to be presented by way of example only and is not limiting. Various alterations, improvements, and modifications may occur and are intended to those skilled in the art, though not expressly stated herein. These alterations, improvements, and modifications are intended to be suggested by the present disclosure, and are within the spirit and scope of the exemplary embodiments of the present disclosure.

Meanwhile, certain terminology has been used to describe embodiments of the present disclosure. For example, the terms "one embodiment," "an embodiment," and/or "some embodiments" mean that a particular feature, structure, or characteristic described in connection with the embodiment is included in at least one embodiment of the present disclosure. Therefore, it is emphasized and should be appreciated that two or more references to "an embodiment," or "one embodiment," or "an alternative embodiment" in various portions of this specification are not necessarily all referring to the same embodiment. Furthermore, the particular features, structures, or feature may be combined as suitable in one or more embodiments of the present disclosure.

Further, it will be appreciated by one skilled in the art, aspects of the present disclosure may be illustrated and described herein in any of a number of patentable classes or context including any new and useful process, machine, manufacture, or collocation of matter, or any new and useful improvement thereof. Accordingly, aspects of the present disclosure may be implemented entirely hardware, entirely software (including firmware, resident software, micro-code, etc.) or combining software and hardware implementation that may all generally be referred to herein as a "data block," "module," "engine," "unit," "component," "assembly," or "system". Furthermore, aspects of the present disclosure may take the form of a computer program product embodied in one or more computer readable media having computer-readable program code embodied thereon.

A computer storage medium may include a propagated data signal with computer readable program code embodied therein, for example, in baseband or as part of a carrier wave. Such a propagated signal may take any of a variety of forms, including electromagnetic, optical, or the like, or any suitable combination thereof. A computer readable signal medium may be any computer readable medium that is not a computer readable storage medium and that may communicate, propagate, or transport a program for use by or in connection with an instruction execution system, apparatus, or device. Program code embodied on a computer readable signal medium may be transmitted using any appropriate medium, including wireless, wireline, optical fiber cable, RF, or the like, or any suitable combination of the foregoing.

Computer program code for carrying out operations for aspects of the present disclosure may be written in a combination of one or more programming languages, including an object oriented programming language such as Java, Scala, Smalltalk, Eiffel, JADE, Emerald, C++, C#, VB. NET, Python or the like, conventional procedural programming languages, such as the "C" programming language, Visual Basic, Fortran 2003, Perl, COBOL 2002, PHP, ABAP, dynamic programming languages such as Python, Ruby, and Groovy, or other programming languages. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider) or in a cloud computing environment or offered as a service such as a Software as a Service (SaaS).

Furthermore, the recited order of processing elements or sequences, or the use of numbers, letters, or other designations thereof, are not intended to limit the claimed processes and methods to any order except as may be specified in the claims. Although the above disclosure discusses through various examples what is currently considered to be a variety of useful embodiments of the disclosure, it is to be understood that such detail is solely for that purpose, and that the appended claims are not limited to the disclosed embodiments, but, on the contrary, are intended to cover modifications and equivalent arrangements that are within the spirit and scope of the disclosed embodiments. For example, although the implementation of various components described above may be embodied in a hardware device, it may also be implemented as a software-only solution, e.g., an installation on an existing server or mobile device.

Similarly, it should be noted that in the foregoing description of embodiments of the present disclosure, various features are sometimes grouped together in a single embodiment, figure, or description thereof for the purpose of streamlining the disclosure aiding in the understanding of one or more of the various embodiments. This method of disclosure, however, is not to be interpreted as reflecting an intention that the claimed subject matter requires more features than are expressly recited in each claim. Rather, claimed subject matter may lie in less than all features of a single foregoing disclosed embodiment.

In some embodiments, the numbers expressing quantities or properties used to describe and claim certain embodiments of the application are to be understood as being modified in some instances by the term "about," "approximate," or "substantially." For example, "about," "approximate," or "substantially" may indicate $\pm 20\%$ variation of the value it describes, unless otherwise stated. Accordingly, in some embodiments, the numerical parameters set forth in the written description and attached claims are approximations that may vary depending upon the desired properties sought to be obtained by a particular embodiment. In some embodiments, the numerical parameters should be construed in light of the number of reported significant digits and by applying ordinary rounding techniques. Notwithstanding that the numerical ranges and parameters setting forth the broad scope of some embodiments of the application are approximations, the numerical values set forth in the specific examples are reported as precisely as practicable.

Each of the patents, patent applications, publications of patent applications, and other material, such as articles, books, specifications, publications, documents, things, and/or the like, referenced herein is hereby incorporated herein by this reference in its entirety for all purposes, excepting any prosecution file history associated with same, any of same that is inconsistent with or in conflict with the present document, or any of same that may have a limiting effect as to the broadest scope of the claims now or later associated with the present document. By way of example, should there be any inconsistency or conflict between the description, definition, and/or the use of a term associated with any of the incorporated material and that associated with the present document, the description, definition, and/or the use of the term in the present document shall prevail.

In closing, it is to be understood that the embodiments of the application disclosed herein are illustrative of the principles of the embodiments of the application. Other modifications that may be employed may be within the scope of the application. Thus, by way of example, but not of limitation, alternative configurations of the embodiments of the application may be utilized in accordance with the teachings herein. Accordingly, embodiments of the present application are not limited to that precisely as shown and described.

**Claims**

1. A vibration device, comprising:

   a mass component;
   one or more piezoelectric components configured to produce a vibration based on an electrical signal; and
   one or more elastic components, wherein at least one elastic component of the one or more elastic components are connected to the mass component and the one or more piezoelectric components;
   wherein the one or more piezoelectric components include a ring structure, and the one or more piezoelectric components are configured to be parallel to an axial direction of the ring structure based on a vibration direction of the electrical signal.

2. The vibration device of claim 1, wherein the one or more piezoelectric components include a first piezoelectric component fixed at one end along an axial direction, and the mass component is connected to a location other than the one end on the first piezoelectric component through at least one elastic component of the one or more elastic components.

3. The vibration device of claim 2, wherein a projection of the mass component along the axial direction of the first piezoelectric component is located within a projection of the first piezoelectric component along the axial direction.

4. The vibration device of claim 2, wherein a shape of the mass component is a ring and a projection of the mass component along the axial direction of the first piezoelectric component is located outside a projection of the first piezoelectric component along the axial direction.

5. The vibration device of claim 4, wherein one side of the mass component along the axial direction of the first piezoelectric component is provided with a cover plate, the side of the mass component being away from the first piezoelectric component.

6. The vibration device of claim 2, wherein the one or more elastic components connected between the mass component and the first piezoelectric component includes a plurality of elastic components, and the plurality of elastic components are distributed along a circumference of the ring structure.

7. The vibration device of claim 6, wherein the plurality of elastic components are located in a same plane perpendicular to the axial direction of the first piezoelectric component.

8. The vibration device of claim 7, wherein a projection of the plurality of elastic components along the axial direction of the first piezoelectric component includes at least two axes of symmetry perpendicular to each other.

9. The vibration device of claim 1, wherein the shape of the one or more elastic components includes at least one of a folded shape, an S-shape, a sample curve shape, an arc shape, or a straight shape.

10. The vibration device of claim 9, wherein each elastic component of the one or more elastic components has a plurality of bending sections, and bending directions of the plurality of bending sections are opposite.

11. The vibration device of claim 1, wherein the one or more elastic components include a first spiral structure and a second spiral structure being connected to the mass component and the one or more piezoelectric components, respectively; and an axis of the first spiral structure is the same with an axis of the second spiral structure, and a spiral direction of the first spiral structure is opposite to a spiral direction of the second spiral structure.

12. The vibration device of claim 1, wherein the one or more piezoelectric components include a first piezoelectric component and a second piezoelectric component, wherein the first piezoelectric component includes a first ring structure and the second piezoelectric component include a second ring structure; and the second piezoelectric component is arranged on an inner side of the first ring structure.

13. The vibration device of claim 12, wherein

   the first piezoelectric component is fixed at one end along the axial direction, and the second piezoelectric component is connected to a location other than the one end on the first piezoelectric component through at least one elastic component of the one or more elastic components; and
   a projection of the mass component along the axial direction is located within a projection of the second piezoelectric component along the axial direction, and the mass component is connected to the second piezoelectric component through at least another elastic component of the one or more elastic components.

14. The vibration device of claim 12, wherein the second piezoelectric component is fixed at one end along the axial direction, the first piezoelectric component is connected to the second piezoelectric component at a location other than the one end on the second piezoelectric component through at least one elastic component of the one or more elastic components; a shape of the mass component is a ring, a projection of the mass component along the axial direction is located outside a projection of the first piezoelectric component along the axial direction, and the mass component is connected to the first piezoelectric component through at least another elastic component of the one or more elastic components.

15. The vibration device of claim 12, wherein a shape of the mass component is a ring, wherein a projection of the mass component along the axial direction is located between a projection of the first piezoelectric component and a projection of the second piezoelectric component along the axial direction; wherein the mass component is connected to the first piezoelectric component through at least one elastic component of the one or more elastic components, and the mass component is connected to the second piezoelectric component through at least another elastic component of the one or more elastic components.

16. The vibration device of claim 15, wherein the first piezoelectric component or the second piezoelectric component has a fixed end along the axial direction.

17. The vibration device of any one of claims 13-16, wherein the one or more elastic components include one or more inner ring elastic components and one or more outer ring elastic components, and bending directions of the one or more inner ring elastic components and the one or more outer ring elastic components are opposite.

18. The vibration device of claim 12, wherein electrical signals received by the first piezoelectric component and the second piezoelectric component includes a phase difference.

19. The vibration device of claim 18, wherein a phase difference is within a range of 45°-180°.

20. The vibration device of claim 1, wherein the one or more piezoelectric components include at least two first piezoelectric components being connected to each other along the axial direction.

21. The vibration device of claim 20, wherein the mass component is connected to the at least two first piezoelectric components through the one or more elastic components, respectively.

22. The vibration device of claim 21, wherein a count of the at least two first piezoelectric components is two, and displacement changes of the two first piezoelectric components are opposite.

23. The vibration device of claim 22, wherein polarities of connecting surfaces of the two first piezoelectric components are the same and potentials of the connecting surfaces are opposite.

24. The vibration device of claim 22, wherein the polarities of the connecting surfaces of the two first piezoelectric components are opposite and the potentials of the connecting surfaces are the same.

25. The vibration device of claim 20, wherein the one or more piezoelectric components include at least two second piezoelectric components, axes of the at least two second piezoelectric components coincide with axes of the at least two first piezoelectric components, a projection of the at least two second piezoelectric components along the axial direction is located inside a projection of the at least two first ring structures along the axial direction; and the at least two second piezoelectric components are interconnected along the axial direction.

26. The vibration device of claim 25, wherein the at least two second piezoelectric components are connected to the at least two first piezoelectric components through the at least one elastic component of the one or more elastic components.

27. The vibration device of claim 26, wherein the mass component is connected to the at least two first piezoelectric components through the at least one elastic component of the one or more elastic components, respectively, or
the mass component is connected to the at least two second piezoelectric components through the at least one elastic component of the one or more elastic components, respectively.

28. The vibration device of claim 25, wherein the mass component is connected to the at least two first piezoelectric components and the at least two second piezoelectric components through the one or more elastic components, respectively.

29. The vibration device of claim 1, wherein the vibration device further includes a piezoelectric beam configured to produce the vibration in the axial direction of the ring structure based on the electrical signal; and the piezoelectric beam is connected to the mass component.

**30.** The vibration device of claim 29, wherein the piezoelectric beam includes at least one first piezoelectric sheet and at least one second piezoelectric sheet being arranged on each side of the piezoelectric beam along the axial direction of the ring structure, respectively, and a polarization direction of the at least one first piezoelectric sheet and a polarization direction of the at least one second piezoelectric sheet are arranged along an opposite direction along the axial direction of the ring structure.

**31.** The vibration device of claim 30, wherein the mass component includes a first mass component and a second mass component, wherein the first mass component is connected to middle of the piezoelectric beam through the at least one elastic component of the one or more elastic components; and each end of the piezoelectric beam is connected to the piezoelectric beam, respectively.

**32.** The vibration device of claim 1, wherein the at least one elastic component of the one or more elastic components resonates with the mass component to produce a first resonant peak; and the one or more piezoelectric components resonate to produce a second resonant peak.

**33.** The vibration device of claim 32, wherein a frequency range of the first resonant peak is within a range of 50 Hz - 2000 Hz.

**34.** The vibration device of claim 32, wherein a frequency range of the first resonant peak is within a range of 50 Hz - 1000 Hz.

**35.** The vibration device of claim 32, wherein a frequency range of the second resonant peak is within a range of 1000 Hz - 50000 Hz.

**36.** The vibration device of claim 32, wherein a frequency range of the second resonant peak is within a range of 1000 Hz - 20000 Hz.

**37.** The vibration device of claim 32, wherein a frequency range of the second resonant peak is within a range of 2000 Hz - 10000 Hz.

**38.** The vibration device of claim 32, wherein a frequency ratio range of the second resonant peak to the first resonant peak ranges is within a range of 20 - 200.

**39.** The vibration device of claim 32, wherein at least two piezoelectric components of the one or more piezoelectric components are interconnected such that the vibration device produces a third resonant peak when vibrating, and a frequency of the third resonant peak is located between the first resonant peak and the second resonant peak.

**40.** The vibration device of claim 39, wherein the at least two piezoelectric components are connected through the at least one elastic component to form a bi-ring structure, and the bi-ring structure resonates to produce the third resonant peak.

**100**

Piezoelectric Component
110

Mass Component
120

Elastic Component
130

**FIG. 1**

**200**

220

210/211

230

Axial Direction

**FIG. 2**

**FIG. 3**

400

Axial Direction

**FIG. 4A**

401 402

**FIG. 4B**

500

520

Axial Direction

531    532

530

511    512

510

**FIG. 5**

**FIG. 6**

**FIG. 7**

**FIG. 8**

**FIG. 9**

**FIG. 10**

**FIG. 11**

FIG. 12

1300-1

**FIG. 13A**

1300-2

**FIG. 13B**

**1400-1**

FIG. 14A

**1400-2**

FIG. 14B

1400-3

FIG. 14C

FIG. 14D

**1500-1**

Up

Axial
Direction

Down

1510    1520

1531    1532

1530

**FIG. 15A**

**1500-2**

1551

1540

1561    1562

1560

**FIG. 15B**

**FIG. 16**

47

1700

1720

1731    1732

1730

1711    1712

1710

FIG. 17

**FIG. 18**

**1900**

FIG. 19

2010

Up

V+\V-

19111
1911
1911
2

2020

Down

**FIG. 20A**

2030

Up

V+\V-
V-\V+

19113
1911
1911
4

2040

Down

**FIG. 20B**

**2100**

2130

2131    2132

Axial
Direction

2120

2111    2112

2110

**FIG. 21**

**FIG. 22**

**FIG. 23**

## 2400

2422

2340

2422

Axial
Direction

2310

2330

2330

2421

FIG. 24

## INTERNATIONAL SEARCH REPORT

| International application No. |
| --- |
| **PCT/CN2022/085557** |

| A. | CLASSIFICATION OF SUBJECT MATTER |
| --- | --- |

H04R 17/10(2006.01)i

According to International Patent Classification (IPC) or to both national classification and IPC

| B. | FIELDS SEARCHED |
| --- | --- |

Minimum documentation searched (classification system followed by classification symbols)

H04R

Documentation searched other than minimum documentation to the extent that such documents are included in the fields searched

Electronic data base consulted during the international search (name of data base and, where practicable, search terms used)

CNTXT; ENTXT; VEN; ENTXTC; CNKI: 振动, 压电, 弹性, 电信号, 环形, 质量, 轴线, vibrat+, piezoelectric, axis, elastic

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 106849738 A (CANON INC.) 13 June 2017 (2017-06-13) description, paragraphs [0039]-[0043], and figures 1-3 | 1-4, 6-7, 9, 20-21 |
| A | CN 110602616 A (WUHAN UNIVERSITY) 20 December 2019 (2019-12-20) entire document | 1-40 |
| A | CN 101536546 A (NEC CORP.) 16 September 2009 (2009-09-16) entire document | 1-40 |
| A | WO 2021131528 A1 (DENSO CORP.) 01 July 2021 (2021-07-01) entire document | 1-40 |

☐ Further documents are listed in the continuation of Box C.　　☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **10 November 2022** | **06 January 2023** |

| Name and mailing address of the ISA/CN | Authorized officer |
| --- | --- |
| **China National Intellectual Property Administration (ISA/ CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/085557**

| Patent document cited in search report | | | Publication date (day/month/year) | Patent family member(s) | | | Publication date (day/month/year) |
|---|---|---|---|---|---|---|---|
| CN | 106849738 | A | 13 June 2017 | JP | 2017108615 | A | 15 June 2017 |
| | | | | US | 2017163176 | A1 | 08 June 2017 |
| | | | | CN | 106849738 | B | 06 August 2019 |
| | | | | US | 10516349 | B2 | 24 December 2019 |
| | | | | JP | 6866128 | B2 | 28 April 2021 |
| CN | 110602616 | A | 20 December 2019 | CN | 110602616 | B | 19 February 2021 |
| | | | | WO | 2021036653 | A1 | 14 March 2021 |
| | | | | SG | 11202201307 | A | 30 March 2022 |
| | | | | US | 2022182767 | A1 | 09 June 2022 |
| CN | 101536546 | A | 16 September 2009 | EP | 2088801 | A1 | 12 August 2009 |
| | | | | WO | 2008056800 | A1 | 15 May 2008 |
| | | | | US | 2010054506 | A1 | 04 March 2010 |
| | | | | JP | WO2008056800 | A1 | 25 February 2010 |
| | | | | US | 8116487 | B2 | 14 February 2012 |
| | | | | CN | 101536546 | B | 03 October 2012 |
| | | | | JP | 5182516 | B2 | 17 April 2013 |
| | | | | EP | 2088801 | A4 | 01 May 2013 |
| | | | | EP | 2088801 | B1 | 07 May 2014 |
| WO | 2021131528 | A1 | 01 July 2021 | KR | 20220104023 | A | 25 July 2022 |
| | | | | JP | WO2021131528 | A1 | 01 July 2021 |
| | | | | CN | 114746360 | A | 12 July 2022 |
| | | | | US | 2022232328 | A1 | 21 July 2022 |

Form PCT/ISA/210 (patent family annex) (January 2015)